(19) Europäisches Patentamt
European Patent Office
Office européen des brevets

(11) **EP 1 723 723 B1**

(12) **EUROPÄISCHE PATENTSCHRIFT**

(45) Veröffentlichungstag und Bekanntmachung des Hinweises auf die Patenterteilung:
**10.09.2008 Patentblatt 2008/37**

(21) Anmeldenummer: **05715000.5**

(22) Anmeldetag: **21.02.2005**

(51) Int Cl.:
***H03K 19/173*** *(2006.01)*

(86) Internationale Anmeldenummer:
**PCT/DE2005/000292**

(87) Internationale Veröffentlichungsnummer:
**WO 2005/088838 (22.09.2005 Gazette 2005/38)**

(54) **LOGIK-GRUNDZELLE, LOGIK-GRUNDZELLEN-ANORDNUNG UND LOGIK-VORRICHTUNG**

LOGIC BASIC CELL, LOGIC BASIC CELL ARRAY AND LOGIC DEVICE

CELLULE DE BASE LOGIQUE, ENSEMBLE CELLULES DE BASE LOGIQUES ET DISPOSITIF LOGIQUE

(84) Benannte Vertragsstaaten:
**DE**

(30) Priorität: **09.03.2004 DE 102004011433**

(43) Veröffentlichungstag der Anmeldung:
**22.11.2006 Patentblatt 2006/47**

(73) Patentinhaber: **Infineon Technologies AG**
**81669 München (DE)**

(72) Erfinder: **GLIESE, Jörg**
**80469 München (DE)**

(74) Vertreter: **Viering, Jentschura & Partner**
**Postfach 22 14 43**
**80504 München (DE)**

(56) Entgegenhaltungen:
**EP-A- 1 122 888**     **US-A- 6 130 553**
**US-A1- 2003 210 073**

- **KIM H ET AL: "Design of heuristic algorithms based on Shannon expansion for low-power logic circuit synthesis" IEE PROCEEDINGS: CIRCUITS DEVICES AND SYSTEMS, INSTITUTION OF ELECTRICAL ENGINEERS, STENVENAGE, GB, Bd. 144, Nr. 6, 3. Dezember 1997 (1997-12-03), Seiten 355-360, XP006008366 ISSN: 1350-2409**

EP 1 723 723 B1

**Beschreibung**

Die Erfindung betrifft eine Logik-Grundzelle, eine Logik-Grundzellen-Anordnung und eine Logik-Vorrichtung.

Mit dem Aufkommen der Digitaltechnik und der sich sprunghaft entwickelnden Mikroprozessortechnik entstand ein Bedarf nach programmierbarer Logik. Ein PLD ("Programmable Logical Device") ist ein integrierter Schaltkreis, der vom Anwender mittels Programmierens in seiner Logikfunktion festgelegt wird. Ein PLD ist eine Architektur für digitale Logikoperationen mit einer Mehrzahl von Schaltern, welche eine Vielzahl von Signalpfaden ermöglichen. Die einem PLD anwenderspezifisch zugeordnete Logikfunktion wird mittels Konfigurierens des PLDs festgelegt.

Zu den PLDs gehören unter anderen Field Programmable Gate Arrays (FPGAs), deren Funktionalität ihnen vom Anwender zugeordnet werden kann, und Mask Programmable Gate Arrays (MPGAs, auch "structured ASIC$_S$" genannt), welchen mittels hardwaremäßigen Konfigurierens eine Logikfunktion zugewiesen werden kann. Via Programmable Gate Arrays (VPGAs) gehören zu den MPGAs.

Eine digitale Logikzelle bildet n Eingangssignale auf ein Ausgangssignal ab. Die Anzahl der möglichen

Abbildungsfunktionen ist $2^{2^n}$. Eine Schaltungsgruppe als digitale Logikzelle wird gemäß dem Stand der Technik z.B. unter Verwendung von sogenannten Look-Up-Tabellen (LUT), anschaulich Nachschlagetabellen, realisiert. Hierfür werden Funktionswerte der Logikfunktion mittels eines Datenwortes von $2^n$ Bit eingestellt. Mit anderen Worten ist die jeweils ausgewählte Logikfunktion in ein Datenwort kodiert. Entsprechend der ausgewählten Logikfunktion werden n Eingangssignale $a_0, a_1, ..., a_{n-1}$ miteinander verknüpft. Somit können die Logikeingangssignale der Logikfunktion $y=f(a_0, a_1, ...a_{n-1})$ als binäre Adresse angesehen werden und in eine One-Hot-Codierung gewandelt werden, um anschließend über Pass-Gate-Logik den Funktionswert zu wählen. Ein solches Verfahren ist zum Beispiel in [1] offenbart.

Alternativ können die Eingänge als Steuereingänge für einen Multiplexer-Baum dienen, siehe [2]. Die Multiplexer können logikbasiert und/oder auf Basis von Transmissions-Gates realisiert werden.

In [3] ist ein FPGA auf Basis einer Look-Up-Tabelle (LUT) offenbart.

Die aus dem Stand der Technik bekannten Logik-Grundzellen unter Verwendung einer Look-Up-Tabelle weisen hinsichtlich Schaltgeschwindigkeit bzw. Störsicherheit Nachteile auf. Die bekannten Lösungen lassen sich ferner für viele Anwendungen nicht ausreichend kompakt im Layout realisieren. Daher ist mit den aus dem Stand der Technik bekannten LUT-Lösungen eine fortgesetzte Skalierung nur schwierig möglich.

Alternativ zu den bekannten LUT-Architekturen sind aus dem Stand der Technik Verschaltungen aus einzelnen Logikgattern bekannt, mit denen eine gewünschte Logikfunktion gebildet werden kann. Allerdings ist eine solche Architektur auf das Bilden einer ganz bestimmten Logikfunktion beschränkt, wohingegen der Gesamtumfang aller möglichen Logikabbildungs-Funktionen unter Verwendung vorgegebener Logikgatter nur sehr aufwendig zu realisieren ist. Auch hinsichtlich der erreichbaren Schaltgeschwindigkeit sind die komplizierten Logikgatter beschränkt. Die Einschränkung des Umfangs der möglichen Logikfunktionen kompliziert die automatische Logikpartitionierung bei einem FPGA Entwurf erheblich.

Ein anderer Ansatz besteht darin, logische Komplexgatter, die eine Verknüpfung von mehreren logischen Eingängen realisieren, flexibel beschaltbar zu machen und durch geschicktes Kombinieren von weniger als den möglichen Eingängen zu einer vollständigen oder fast vollständigen Abdeckung des kombinatorischen Funktionsraums zu gelangen. Eine solche Realisierung weist jedoch den Nachteil auf, dass Flexibilität außerhalb der Zelle zur inneren logischen Konfiguration der Zelle benutzt wird und damit eingeschränkt ist. Außerdem ist das funktionelle Mapping in der Regel aufwendig.

Weiterhin ist aus [4] ein konfigurierbares NAND/NOR-Element bekannt.

[5] beschreibt einen Schaltkreis zum Durchführen eines heuristischen Algorithmus basierend auf einer Shannon-Expansion.

Weiterhin ist aus [6] ein programmierbarer Funktionsblock bekannt, der einen Volladdierer und mindestens eine Präpositionslogik, sowie einen Eingabeblock mit programmierbaren Eingabeschaltereinheiten aufweist. Die Präpositionslogik weist einen Exklusiv-ODER-Schaltkreis auf, sowie einen Multiplexer und Funktionen wie verschiedene unterschiedliche Logikschaltkreise, wobei mittels des Setzens einiger Eingänge der verschiedenen Logikschaltkreise ihre jeweilige Logikfunktion neu eingestellt werden kann.

[7] beschreibt einen programmierbaren Logik-Schaltkreis basierend auf Look-up-Tabellen.

Weiterhin beschreibt [8] eine Logik-Zelle zum Bereitstellen einer vorgegebenen Logikoperation gemäß einer Mehrzahl von Eingangssignalen, wobei ein Logikbaum-Schaltkreis mit einer Mehrzahl von Schalterelementen zwischen einen Ausgangsknoten und ein Referenzpotential geschaltet ist, wobei die Schalterelemente, die dem Referenzpotential am nächsten angeordnet sind, gesteuert werden von einem Signal, das unter der Mehrzahl von Eingangssignalen am frühesten ankommt, und wobei das Schalterelement, das am nächsten an dem Ausgangs-Knoten angeordnet ist, gesteuert wird von einem Signal, das unter der Mehrzahl der Eingangssignale am spätesten ankommt. Weiterhin ist ein Ausgabe-Schaltkreis mit dem Ausgangs-Knoten verbunden, wobei der Ausgabe-Schaltkreis eingerichtet ist zum Ausgeben des Signals des Ausgangs-Knoten gemäß dem Signal, das unter der Mehrzahl von Eingangssignalen am spätesten ankommt.

Der Erfindung liegt insbesondere das Problem zugrunde, eine Logik-Grundzelle bereitzustellen, die mit vertretbarem Flächenaufwand fertigbar ist und eine ausreichend gute Signalverarbeitungsgeschwindigkeit aufweist.

Das Problem wird durch eine Logik-Grundzelle, durch eine Logik-Grundzellen-Anordnung und durch eine Logik-Vorrichtung mit den Merkmalen gemäß den unabhängigen Patentansprüchen gelöst.

Die erfindungsgemäße Logik-Grundzelle zum Bilden eines Ausgangssignals aus mindestens drei Eingangssignalen gemäß einer vorgebbaren Logikfunktion enthält einen ersten Logikfunktionsblock mit zwei Datensignaleingängen, an denen ein erstes Eingangssignal und ein zweites Eingangssignal anlegbar sind, und mit einem Datensignalausgang zum Bereitstellen einer Logikverknüpfung des ersten Eingangssignals und des zweiten Eingangssignals gemäß einer vorgebbaren ersten Logikteilfunktion. Ferner enthält die Logik-Grundzelle einen zweiten Logikfunktionsblock mit zwei Datensignaleingängen, an denen das erste Eingangssignal und das zweite Eingangssignal anlegbar sind, und mit einem Datensignalausgang zum Bereitstellen einer Logikverknüpfung des ersten Eingangssignals und des zweiten Eingangssignals gemäß einer vorgebbaren zweiten Logikteilfunktion. Ferner ist ein erster Logik-Transistor mit einem ersten Source-/Drain-Anschluss bereitgestellt, der mit dem Datensignalausgang des ersten Logikfunktionsblocks gekoppelt ist, mit einem Gate-Anschluss, an dem ein drittes Eingangssignal bereitstellbar ist, und mit einem zweiten Source-/Drain-Anschluss, an dem das Ausgangssignal bereitstellbar ist. Darüber hinaus ist ein zweiter Logik-Transistor mit einem zweiten Source-/Drain-Anschluss bereitgestellt, der mit dem Datensignalausgang des zweiten Logikfunktionsblocks gekoppelt ist, mit einem Gate-Anschluss, an dem ein zu dem dritten Eingangssignal komplementäres Signal bereitstellbar ist, und mit einem zweiten Source-/Drain-Anschluss, der mit dem zweiten Source-/Drain-Anschluss des ersten Logik-Transistors gekoppelt ist.

Die erfindungsgemäße Logik-Grundzellen-Anordnung zum Bilden eines Ausgangssignals aus mindestens vier Eingangssignalen gemäß einer vorgebbaren Logikfunktion enthält eine erste Logik-Grundzelle mit den oben beschriebenen Merkmalen. Ferner ist ein dritter Logik-Transistor bereitgestellt, mit einem ersten Source-/Drain-Anschluss, an den das Ausgangssignal der ersten Logik-Grundzelle anlegbar ist, mit einem Gate-Anschluss, an dem ein viertes Eingangssignal bereitstellbar ist, und mit einem zweiten Source-/Drain-Anschluss, an dem das Ausgangssignal der Logik-Grundzellen-Anordnung bereitstellbar ist. Darüber hinaus enthält die Logik-Grundzellen-Anordnung einen zweite Logik-Grundzelle mit den oben beschriebenen Merkmalen. Ferner ist ein vierter Logik-Transistor bereitgestellt, mit einem ersten Source-/Drain-Anschluss, an dem das Ausgangssignal der zweiten Logik-Grundzelle anlegbar ist, mit einem Gate-Anschluss, an dem ein zu dem vierten Eingangssignal komplementäres Signal bereitstellbar ist, und mit einem zweiten Source-/Drain-Anschluss, der mit dem zweiten Source-/Drain-Anschluss des dritten Logik-Transistors gekoppelt ist.

Ferner ist erfindungsgemäß eine Logik-Vorrichtung zum Bilden einer logischen Verknüpfung von mehr als vier Datensignalen geschaffen, die eine Mehrzahl von Logik-Grundzellen-Anordnung mit den oben beschriebenen Merkmalen aufweist.

Eine Grundidee der Erfindung beruht darauf, in einer Logik-Grundzelle zwei mittels zweier Logikfunktionsblöcke generierte Logik-Verknüpfungen einer ersten Anzahl von Eingangssignalen miteinander in vorteilhafter Weise so zu verknüpfen, dass mit geringem Hardware-Aufwand eine komplexere Logikfunktion einer größeren Anzahl von Eingangssignalen realisiert wird. Eine zu realisierende komplexe Logikfunktion wird anschaulich basierend auf der sogenannten Shannon-Zerlegung auf einfachere Logikteilfunktionen zurückgeführt, und dies in schaltungstechnisch besonders einfacher Weise mittels zweier Logik-Transistoren.

Mit der in Gleichung (1) dargestellten Shannon-Zerlegung kann eine Logikfunktion $y(a_0, a_1, a_2)$ von beispielsweise drei Eingangssignalen $a_0$, $a_1$, $a_2$ in zwei Logikteilfunktionen $y_0(a_1, a_0)$, $y_1(a_1, a_0)$ zerlegt werden, welche Logikteilfunktionen von einem Eingangssignal nicht mehr abhängen. Das Bilden der Funktion y aus $y_0$ und $y_1$ erfolgt unter Verwendung des dritten Eingangssignals $a_2$ und des dazu logisch komplementären Signals $\overline{a_2}$:

$$y(a_2, a_1, a_0) = \overline{a_2} \cdot y_0(a_1, a_0) \lor a_2 \cdot y_1(a_1, a_0) \quad (1)$$

Verallgemeinert auf eine Funktion f von n Eingangssignalen, die auf zwei Teilfunktionen $f_0$, $f_1$ von jeweils (n-1) Eingangssignalen zurückgeführt wird, ergibt sich

$$f(a_n, a_{n-1}, \ldots, a_1, a_0) = \overline{a_n} \cdot f_0(a_{n-1}, \ldots, a_0) \lor a_n \cdot f_1(a_{n-1}, \ldots, a_0)$$
$$(2)$$

Anschaulich wird eine Aussage der booleschen Logik als Grundlage für eine Schaltungsarchitektur verwendet, welche in der erfindungsgemäßen Logik-Grundzelle realisiert ist. Die Funktion $f(a_n, a_{n-1}, ..., a0)$ von n+1 Eingangssignalen $a_i$ lässt sich gemäß der booleschen Logik gemäß Gleichung (2) auf zwei Funktionen $f_0$, $f_1$ von jeweils n Eingangssignalen $a_i$ zurückführen.

Für den Fall n=2, das heißt für eine Funktion von n+1=3 Eingangssignalen, ist somit die Logikgesamtfunktion f als Funktion dreier Eingangssignale auf zwei Logikteilfunktionen $f_0$ und $f_1$ von je zwei Eingangssignalen zurückgeführt. Jede der Logikteilfunktionen $f_0$, $f_1$ kann von einem der Logikfunktionsblöcke einer Logik-Grundzelle realisiert werden.

Erfindungsgemäß wird die Rückführung einer Funktion f von allgemein n Variablen auf zwei Funktionen mit jeweils (n-1) Variablen dadurch realisiert, dass die ersten und zweiten Logik-Transistoren in der beschriebenen Weise mit den Datensignalausgängen der ersten und zweiten Logikfunktionsblöcke verschaltet werden. Diese Realisierung stellt eine schaltungstechnisch besonders vorteilhafte Verwirklichung von Gleichung (1) bzw. (2) dar, bei der eine geringe Anzahl verwendeter Transistoren mit einer hohen Signalverarbeitungsgeschwindigkeit und einem geringen Flächenbedarf auf einem Halbleiterwafer kombiniert sind.

Anschaulich wird in einem ersten Logikfunktionsblock, dessen Aufbau beliebig ist, die Logikfunktion $y_0(a_1, a_0)$ (bzw. allgemein $f_0$ gemäß Gleichung (2)) dadurch realisiert, dass an den Eingängen des ersten Logikfunktionsblocks die Eingangssignale $a_0$, $a_1$ bereitgestellt werden und der Logikfunktionsblock hinsichtlich seiner Funktionalität derart eingerichtet ist, dass er die Logikfunktion $y_0$ realisiert. Ferner wird in einem zweiten Logikfunktionsblock die Funktion $y_1(a_1, a_0)$ (bzw. allgemein $f_1$ gemäß Gleichung (2)) realisiert, indem an den Eingängen des zweiten Logikfunktionsblocks die Datensignale $a_1$, $a_0$ bereitgestellt werden und das Ausgangssignal $y_1(a_1, a_0)$ an dem Ausgang des zweiten Logikfunktionsblocks bereitgestellt ist. Unter Verwendung von nur zwei Transistoren, nämlich des ersten und des zweiten Logik-Transistors, werden die gemäß den auswählbaren Logikteilfunktionen gebildeten Logikfunktionswerte $y_0$, $y_1$ (bzw. allgemein $f_0$, $f_1$ gemäß Gleichung (2)) derart mit dem dritten Datensignal $a_2$ bzw. mit dem dazu logisch komplementären Signal $\overline{a_2}$ verknüpft, dass gemäß Gleichung (1) bzw. (2) die Gesamtfunktion y bzw. f realisiert wird. Diese Verknüpfung ist erfindungsgemäß mit lediglich zwei zusätzlichen Feldeffekttransistoren realisierbar, so dass eine schaltungstechnisch äußerst günstige Verkopplung der Datensignale $a_0$, $a_1$, $a_2$ ermöglicht ist.

Anschaulich ist erfindungsgemäß die Verwendung eines expliziten Multiplexers zum Verkoppeln der Logikteilfunktionen $y_0$, $y_1$ mit dem dritten Datensignal $a_2$ bzw. dessen logisch komplementären Signal $\overline{a_2}$ vermieden. Die Funktionalität eines Multiplexers wird anschaulich von den zwei Logik-Transistoren erfüllt.

Anders ausgedrückt ermöglicht die Erfindung eine Realisierung von Funktionen von mehr als zwei Eingangssignalen mit einer geringen Anzahl von Transistoren, wobei ein expliziter Multiplexer entbehrlich ist, so dass nur eine optimal geringe Anzahl von Transistoren erforderlich ist.

Ein wichtiger Aspekt der Erfindung besteht darin, die dritte (bzw. eine vierte oder zusätzliche) Schaltvariable in einem Transistorserienpfad derart anzuordnen bzw. derart zu verschalten, dass der Eingang mit der höchsten Wertigkeit direkt den Ausgang schaltet.

Mit der erfindungsgemäßen Logik-Grundzelle bzw. mit der darauf basierenden Logik-Grundzellen-Anordnung ist es ermöglicht, Logikfunktionen hoher Komplexität zwecks besserer Verarbeitbarkeit auf Logikfunktionen geringerer Komplexität zurückzuführen, und dies mit einer schaltungstechnisch äußerst vorteilhaften Anordnung von Transistoren zu realisieren, die nur eine geringe Fläche auf einem Chip erfordern und eine schnelle Verarbeitung der zu verknüpfenden Signale sicherstellen.

Anders ausgedrückt kann erfindungsgemäß durch eine Verschaltung von Logik-Grundzellen miteinander eine beliebige, komplizierte Logikgesamtfunktion, die abhängig von einer Vielzahl von Eingangssignalen ist, auf mehrere einfachere Logikteilfunktionen von einer geringeren Anzahl von Eingangssignalen zurückgeführt werden. Die erfindungsgemäße Lösung basiert auf der booleschen Logik und realisiert diese in einer vorteilhaften, vorzugsweise halbleitertechnologischen Schaltungsarchitektur.

Die Auswahl einer Logikteilfunktion (zum Beispiel UND-Verknüpfung, ODER-Verknüpfung, Exklusiv-ODER-Verknüpfung, Nicht-UND-Verknüpfung, Nicht-ODER-Verknüpfung, Nicht-Exklusiv-ODER-Verknüpfung, etc.) eines Logikfunktionsblocks kann beispielsweise mittels Konfigurierens von Logikfunktionskonfigurationseingängen des jeweiligen Logikfunktionsblocks erfolgen. In der schaltungstechnischen Realisierung kann ein Logikfunktionsblock miteinander verschaltete Transistoren aufweisen, wobei mittels Anlegens von Logikfunktionssignalen an Logikfunktionskonfigurationseingänge der Logikfunktionsblöcke bestimmte Pfade innerhalb des Transistornetzwerks durchgeschaltet werden können, so dass Eingangssignale gemäß diesen ausgewählten Pfaden gemäß einer vorgebbaren Logikfunktion verarbeitbar sind.

Bevorzugte Weiterbildungen der Erfindung ergeben sich aus den abhängigen Ansprüchen.

Bei der erfindungsgemäßen Logik-Grundzelle kann der erste Logikfunktionsblock und der zweite Logikfunktionsblock jeweils mindestens einen zusätzlichen Datensignaleingang aufweisen, wobei an jedem der zusätzlichen Datensignaleingänge ein zusätzliches Eingangssignal anlegbar ist, womit die Logik-Grundzelle zum Bilden eines Ausgangssignals aus mindestens vier Eingangssignalen gemäß einer vorgebbaren Logikfunktion eingerichtet ist. Anders ausgedrückt sind gemäß dieser Ausgestaltung an jeden der Logikfunktionsblöcke mehr als zwei Eingangssignale angelegt, so dass der entsprechende Logikfunktionsblock eine Logikteilfunktion von mindestens drei Eingangssignalen realisiert. Somit ist die erfindungsgemäße Logik-Grundzelle nicht auf die Verknüpfung von insgesamt drei Datensignalen miteinander beschränkt, sondern kann gemäß Gleichung (2) mit einer beliebigen Anzahl von Daten- oder Eingangssignalen betrieben werden. Dies ermöglicht auch sehr komplexe Verknüpfungen von vielen Datensignalen.

Der erste Logikfunktionsblock und der zweite Logikfunktionsblock werden erfindungsgemäß jeweils aus einer Mehrzahl von miteinander gemäß der jeweiligen Logik-Teilfunktion verschalteten Datensignal-Transistoren gebildet. Somit besteht die Logik-Grundzelle vollständig aus Transistoren (vorzugsweise Feldeffekttransistoren) und kann daher mit den ausgereiften Methoden der Silizium-Mikroelektronik gefertigt werden.

Die Logik-Transistoren und die Datensignal-Transistoren sind erfindungsgemäß Transistoren eines ersten Leitungstyps, und die Transistoren des ersten Leitungstyps bilden einen ersten Datensignalpfad. Ferner existiert erfindungsgemäß ein zweiter Datensignalpfad aus Transistoren eines zweiten Leitungstyps, der zu dem ersten Leitungstyp komplementär ist, wobei zu jedem der Transistoren des ersten Datensignalpfads ein entsprechend verschalteter Transistor in dem zweiten Datensignalpfad bereitgestellt ist. Die zweiten Source-/Drain Anschlüsse der Logik-Transistoren des ersten Datensignalpfads und die zweiten Source-/Drain Anschlüsse der Logik-Transistoren des zweiten Datensignalpfads sind in der erfindungsgemäßen Logik-Grundzelle miteinander gekoppelt.

Die Transistoren des ersten Leitungstyps können zum Beispiel Transistoren des n-Leitungstyps sein, wohingegen die Transistoren des zweiten Leitungstyps Transistoren des p-Leitungstyps sein können, oder vice versa. Somit kann die erfindungsgemäße Logik-Grundzelle beispielsweise unter Verwendung einer CMOS-Architektur gebildet sein.

Die erfindungsgemäße Logik-Grundzelle kann mit einem Evaluierungs-Schalter versehen sein, an dem das Ausgangssignal anlegbar ist, und mit einem Vorlade-Schalter, welche Schalter derart verschaltet und steuerbar sind, dass an einem Ausgang der Logik-Grundzelle bei geöffnetem (das heißt Signaltransfer erlaubenden) Evaluierungs-Schalter und geschlossenem (das heißt Signaltransfer nicht erlaubenden) Vorlade-Schalter das Ausgangssignal bereitgestellt ist. Ferner kann an dem Ausgang der Logik-Grundzelle bei geöffnetem (das heißt Signaltransfer erlaubenden) Vorlade-Schalter und geschlossenem (das heißt Signaltransfer nicht erlaubenden) Evaluierungs-Schalter ein Referenzsignal bereitgestellt ist. Der Evaluierungs-Schalter und der Vorlade-Schalter können jeweils Transistoren sein, insbesondere Feldeffekttransistoren oder Bipolartransistoren.

Gemäß dieser Ausgestaltung kann mittels des Vorlade- oder Precharge-Schalters der Ausgang auf das Referenzpotential vorgeladen werden (Precharge-Phase), zum Beispiel während der ersten Hälfte einer Schaltperiode der Logik-Grundzelle. Mittels des Evaluierungs-Schalters kann an dem Ausgang das gemäß der vorgegebenen Logikfunktion verarbeitete Ausgangssignal bereitgestellt werden, zum Beispiel während der zweiten Hälfte der Schaltperiode der Logik-Grundzelle (Evaluate-Phase).

Die erfindungsgemäße Logik-Grundzelle kann als CMOS Logik-Grundzelle eingerichtet sein.

Gemäß einer Ausgestaltung der Erfindung kann zumindest einer der Logikfunktionsblöcke in der Struktur eines Programmable Logic Device (PLD), eines Field-Programmable Gate Array (FPGA), eines maskenprogrammierten Application-Specific. Integrated Circuit (mASIC), eines Logikgatters oder einer Anordnung mehrerer Logikgatter oder einer Look-Up-Tabelle gebildet sein. Erfindungsgemäß kann im Prinzip jede beliebige Ausgestaltung für die Logikfunktionsblöcke gewählt werden. Im Falle der Ausgestaltung eines Logikfunktionsblocks als Look-Up-Tabelle kann beispielsweise die aus [3] bekannte Architektur in der Logik-Grundzelle der Erfindung implementiert werden. Im Falle der Realisierung eines Logikfunktionsblocks als maskenprogrammierter Application-Specific Integrated Circuit bzw. als "structured ASIC" kann eine gewünschte Logikteilfunktion eines Logikfunktionsblocks mittels Festverdrahtens von Transistoren innerhalb des Logikfunktionsblocks realisiert werden. Mit anderen Worten kann unter Verwendung von Vias oder anderen fest implementierten Kopplungselementen ein bestimmter Signalpfad bzw. mehrere Signalpfade innerhalb der Transistor-Anordnung eines solchen "structured ASICs" erlaubt werden, wodurch dem Logikfunktionsblock dauerhaft eine feste Logikfunktion zugeordnet ist.

An mindestens einem Logikkonfigurationseingang von zumindest einem der Logikfunktionsblöcke kann die realisierbare Logikteilfunktion unveränderlich vorgegeben werden. Gemäß dieser Ausgestaltung erfüllt der Logikfunktionsblock stets die ihm fest und unveränderlich zugewiesene Logikteilfunktion, da diese mittels Anlegens vorgegebener Signale (oder Betriebsspannungen) an den Logikkonfigurationseingängen fest eingestellt ist. Die vorgegebene Logikteilfunktion kann auch festverdrahtet mittels Kurzschließens oder entsprechenden hardwaremäßigen Koppelns der Transistoren des Logikfunktionsblocks realisiert werden. Dann können an die in festgelegter Weise miteinander verschalteten Transistoren über einen oder mehrere Anschlüsse des Logikfunktionsblocks vorgegebene elektrische Potentiale (zum Beispiel Betriebsspannung, Massepotential) angelegt werden. Bei fest vorgegebener Logikteilfunktion eines Logikfunktionsblocks kann eine mit dem mindestens einen Logikkonfigurationseingang gekoppelte Speichereinrichtung vorgesehen sein, in welcher die Information zum Vorgeben der realisierbaren Logikteilfunktion speicherbar ist. Somit ist in einer solchen Speichereinrichtung ein Datenwort speicherbar, in welchem die Logikteilfunktion des Logikfunktionsblocks kodiert ist, zum Beispiel als binäres Datenwort.

Alternativ zu der beschriebenen Ausgestaltung kann an mindestens einem Logikfunktionskonfigurationseingang eines jeweiligen Logikfunktionsblocks die realisierbare Logikteilfunktion mittels eines anlegbaren Signals variabel vorgegeben sein. Bei dieser Ausgestaltung des Logikfunktionsblocks kann dieser jede beliebige Logikfunktion durchführen, welche der Logik-Grundzelle mittels eines (zum Beispiel zeitlich) veränderlichen elektrischen Potentials an Steuereingängen von Transistoren innerhalb des Logikfunktionsblocks vorgegeben ist. In diesem Szenario kann der Logikfunktionsblock als variable Logikkomponente der übergeordneten Logik-Grundzelle bzw. der dieser übergeordneten Logik-Grundzellen-Anordnung verschaltet werden, was eine flexible Schaltungsarchitektur ermöglicht.

Die erfindungsgemäße Logik-Grundzelle ist vorzugsweise zum Verarbeiten von digitalen Datensignalen eingerichtet, welche einen logischen Wert "1" oder "0" aufweisen.

Gemäß einem bevorzugten Ausführungsbeispiel der erfindungsgemäßen Logik-Grundzelle weist zumindest einer der Logikfunktionsblöcke ferner einen ersten Komplementär-Datensignaleingang auf, an den das zu dem ersten Eingangssignal logisch komplementäre Signal anlegbar ist, und weist einen zweiten Komplementär-Datensignaleingang auf, an den das zu dem zweiten Eingangssignal logisch komplementäre Signal anlegbar ist. Ein erstes Logikauswahl-Element ist zwischen dem ersten Datensignaleingang und dem zweiten Datensignaleingang gebildet. Ein zweites Logikauswahl-Element ist zwischen dem ersten Datensignaleingang und dem zweiten Komplementär-Datensignaleingang gebildet. Ein drittes Logikauswahl-Element ist zwischen dem zweiten Datensignaleingang und dem ersten Komplementär-Datensignaleingang gebildet. Ein viertes Logikauswahl-Element ist zwischen dem ersten Komplementär-Datensignaleingang und dem zweiten Komplementär-Datensignaleingang gebildet. An dem Datensignalausgang ist die Logik-Verknüpfung der zwei Datensignale gemäß der mittels der Logikauswahl-Elemente ausgewählten Logikfunktion bereitstellbar.

Gemäß dieser Ausgestaltung ist zumindest einer der Logikfunktionsblöcke der Logik-Grundzelle in einer solchen schaltungstechnischen Realisierung bereitgestellt, dass bei einer sehr geringen Anzahl von erforderlichen Komponenten (zum Beispiel Transistoren) eine komplette Abbildung des kombinatorischen Funktionsraums über n Eingängen erreicht ist. Mit anderen Worten ist es mit dieser Ausgestaltung der Logikfunktionsblöcke ermöglicht, jede mögliche Logikverknüpfung von zwei Datensignalen in einer optimierten Verschaltung von Logikauswahl-Elementen und Datensignaleingängen zu realisieren. In Kombination mit den Logik-Transistoren der Logik-Grundzelle kann somit eine schaltungstechnisch äußerst effiziente Verknüpfung von drei Datensignalen ermöglicht werden. Anschaulich sind die Logikauswahl-Elemente des Logikfunktionsblocks derart konfiguriert, dass sie die von der erfindungsgemäßen Logik-Grundzelle realisierte Logikfunktion determinieren. Dies kann zum Beispiel durch eine hartverdrahtete Realisierung der Logikauswahl-Elemente erreicht werden, so dass in diesem Fall die Logikfunktion mittels der durch die Logikauswahl-Elemente vorgegebenen unveränderlichen Verdrahtung der Datensignaleingänge bestimmt ist. Alternativ können die Logikauswahl-Elemente zum Beispiel als Logikauswahl-Transistoren vorgesehen sein, wobei mittels Anlegens von Logikauswahlsignalen an deren Gate-Anschlüsse die zu realisierende Logikfunktion vorgegeben wird.

Diese Architektur eines Logikfunktionsblocks stellt eine sehr einfache Anordnung dar, bei der es mit schaltungstechnisch sehr geringem Aufwand ermöglicht ist, jede mögliche Logikfunktion von zwei Eingängen zu realisieren. Die besonders kompakte Realisierung der Logikfunktionsblöcke gemäß der beschriebenen Ausgestaltung spart Chipfläche und ermöglicht somit eine miniaturisierte Realisierung der Logik-Grundzelle.

Die Logikauswahl-Elemente können unveränderliche Hardwareelemente sein. Gemäß dieser Realisierung wird die gewünschte Logikfunktion einmal fest vorgegeben, und zwar mittels Verdrahtens der vier Datensignaleingänge in einer vorgegebenen Weise. Die vorgegebene Kopplung zwischen den einzelnen Datensignalen, die an den Datensignaleingängen bereitgestellt werden, wird durch die Verschaltung der Logikauswahl-Elemente vorgegeben und führt somit zu einer eindeutigen Logikfunktion.

Gemäß der beschriebenen Konfiguration können die Logikauswahl-Elemente mittels einer Mehrzahl von Metallisierungsebenen und/oder Vias realisiert werden.

Bei dem Logikfunktionsblock gemäß der beschriebenen Ausgestaltung der Erfindung kann das erste Logikauswahl-Element ein erster Logik-Transistor sein, der mittels eines ersten Logikauswahlsignals steuerbar ist. Das zweite Logikauswahl-Element kann ein Logik-Transistor sein, der mittels eines zweiten Logikauswahlsignals steuerbar ist. Das dritte Logikauswahl-Element kann ein dritter Logik-Transistor sein, der mittels eines dritten Logikauswahlsignals steuerbar ist. Das vierte Logikauswahl-Element kann ein vierter Logik-Transistor sein, der mittels eines vierten Logikauswahl-Elements steuerbar ist. Gemäß dieser Ausgestaltung werden vier Logikauswahlsignale an die Logik-Transistoren, vorzugsweise an deren Gate-Anschlüsse, angelegt, wodurch eine ganz bestimmte Kopplung der Datensignale an den Datensignaleingängen realisiert wird. Gemäß dieser speziellen Kopplung, die variabel vorgebbar ist, wird die realisierte Logikfunktion vorgegeben.

Ferner kann der Logikfunktionsblock gemäß der beschriebenen Ausgestaltung vier Datensignal-Transistoren aufweisen, an deren Gate-Anschlüssen jeweils eines der Datensignale oder der logisch komplementären Datensignale bereitstellbar ist. Bei dieser Ausgestaltung werden die vier Datensignale, das heißt das erste Datensignal und das dazu logisch komplementäre Datensignal, sowie das zweite Datensignal und das dazu logisch komplementäre Datensignal über Gate-Anschlüsse von vier Datensignal-Transistoren in den Logikfunktionsblock eingekoppelt.

Gemäß der beschriebenen Ausgestaltung kann ein erster Datensignal-Transistor derart verschaltet sein, dass ein erster Source-/Drain-Anschluss mit einem ersten Source-/Drain-Anschluss des ersten Logik-Transistors und mit einem zweiten Source-/Drain-Anschluss des zweiten Logik-Transistors gekoppelt ist. Ferner kann der zweite Source-/Drain-Anschluss des zweiten Datensignal-Transistors mit einem ersten Source-/Drain-Anschluss eines dritten Datensignal-Transistors gekoppelt sein.

Der dritte Datensignal-Transistor kann derart verschaltet sein, dass dessen zweiter Source-/Drain-Anschluss mit einem ersten Source-/Drain-Anschluss des vierten Logik-Transistors und mit einem ersten Source-/Drain-Anschluss des zweiten Logik-Transistors gekoppelt ist.

Ein zweiter Datensignal-Transistor kann derart verschaltet sein, dass dessen erster Source-/Drain-Anschluss mit einem zweiten Source-/Drain-Anschluss des ersten Logik-Transistors und mit einem zweiten Source-/Drain-Anschluss des dritten Logik-Transistors gekoppelt ist. Ein zweiter Source-/Drain-Anschluss des ersten Datensignal-Transistors kann mit einem ersten Source-/Drain Anschluss eines vierten Datensignal-Transistors gekoppelt sein. Der vierte Datensignal-Transistor kann derart verschaltet sein, dass dessen zweiter Source-/Drain-Anschluss mit einem zweiten Source-/Drain-Anschluss des dritten Logik-Transistors und mit einem zweiten Source-/Drain-Anschluss des vierten Logik-Transistors gekoppelt ist.

Die beschriebene Verschaltung der vier Datensignal-Transistoren mit den vier Logik-Transistoren stellt eine bevorzugte schaltungstechnische Realisierung eines Logikfunktionsblocks einer Logik-Grundzelle zum Realisieren einer möglichen Logikfunktion zum Verknüpfen der Datensignale bereit, und dies mit schaltungstechnisch sehr geringem Aufwand.

Wenngleich Ausgestaltungen der Logik-Grundzelle beschrieben worden sind, so sollen diese Ausgestaltungen auch für die erfindungsgemäße Logik-Grundzellen-Anordnung und die erfindungsgemäße Logik-Vorrichtung gelten.

Ausführungsbeispiele der Erfindung sind in den Figuren dargestellt und werden im Weiteren näher erläutert.

Es zeigen:

Figur 1          eine Logik-Grundzelle gemäß einem Ausführungsbeispiel der Erfindung,

Figur 2          eine Tabelle, in der die Korrelation zwischen Werten von vier Logikauswahlsignalen und einer von der Logik-Grundzelle gemäß Figur 1 realisierten Logikfunktion dargestellt sind,

Figur 3          einen Logikfunktionsblock einer Logik-Grundzelle gemäß einem Ausführungsbeispiel der Erfindung,

Figur 4          eine Logik-Grundzellen-Anordnung gemäß einem ersten Ausführungsbeispiel der Erfindung,

Figur 5          eine Logik-Grundzellen-Anordnung gemäß einem zweiten Ausführungsbeispiel der Erfindung,

Figuren 6A und 6B          einen p-MOS-Teilpfad und einen n-MOS-Teilpfad eines Logikfunktionsblocks einer Logik-Grundzelle gemäß einem Ausführungsbeispiel der Erfindung.

Gleiche oder ähnliche Komponenten in unterschiedlichen Figuren sind mit gleichen Bezugsziffern versehen.

Die Darstellung in den Figuren ist schematisch und nicht maßstäblich.

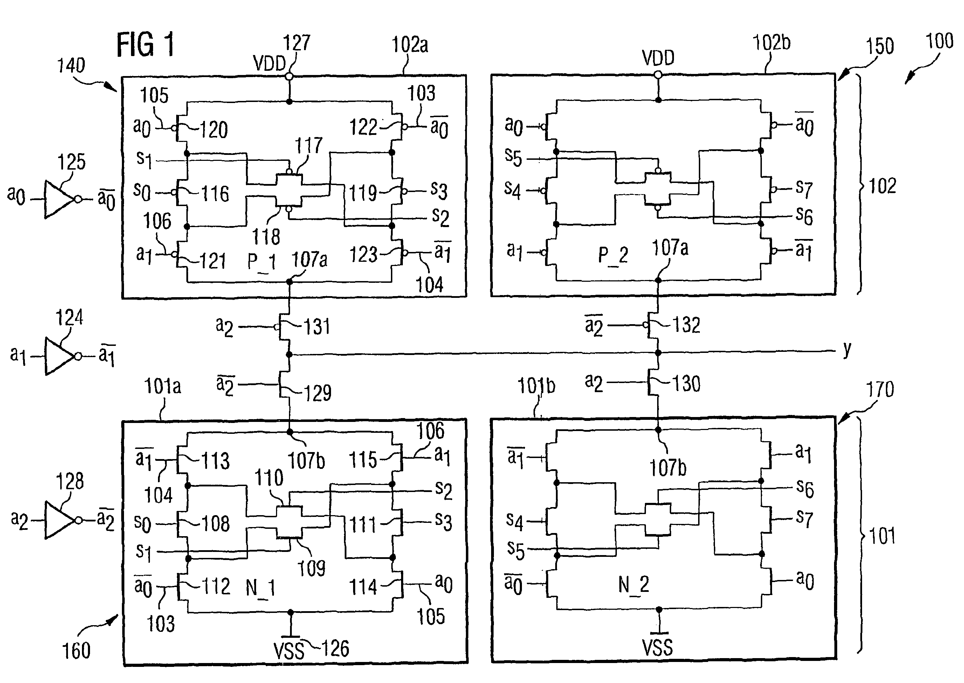

Im Weiteren wird bezugnehmend auf **Fig.1** eine Logik-Grundzelle 100 gemäß einem Ausführungsbeispiel der Erfindung beschrieben.

Die Logik-Grundzelle 100 weist einen ersten Datensignalpfad 101 aus n-MOS-Transistoren und einen zweiten Datensignalpfad 102 aus p-MOS-Transistoren auf. Der erste Datensignalpfad 101 enthält einen ersten Logikfunktionsblock 160 und einen zweiten Logikfunktionsblock 170. Der zweite Datensignalpfad 102 enthält einen ersten Logikfunktionsblock 140 und einen zweiten Logikfunktionsblock 150.

Im Weiteren wird die Struktur des ersten Logikfunktionsblocks 160 des ersten Datensignalpfads 101 näher beschrieben.

Der erste Logikfunktionsblock 160 des ersten Datensignalpfads 101 weist einen ersten Datensignaleingang 103 auf, an dem ein zu einem ersten Datensignal $a_0$ komplementäres erstes komplementäres Datensignal $\overline{a_0}$ bereitgestellt ist. Ferner ist an einem zweiten Datensignaleingang 104 ein zu einem zweiten Datensignal $a_1$ komplementäres zweites komplementäres Datensignal $\overline{a_1}$ bereitgestellt. An einem dritten Datensignaleingang 105 ist das erste Datensignal $a_0$ bereitgestellt. Darüber hinaus ist an einem vierten Datensignaleingang 106 das zweite Datensignal $a_1$ bereitgestellt.

An einem Datensignalausgang 107b des ersten Logikfunktionsblocks 160 des ersten Datensignalpfads 101 ist ein Ausgangssignal des ersten Logikfunktionsblocks 160, das heißt eine Logikverknüpfung des ersten Eingabesignals $a_0$, $\overline{a_0}$ und des zweiten Eingabesignals $a1$, $\overline{a_1}$ gemäß einer vorgebbaren Logikteilfunktion bereitgestellt.

Als ein erstes Logikauswahl-Element ist ein erster n-MOS-Logikauswahl-Transistor 108 zwischen dem ersten Datensignaleingang 103 und dem zweiten Datensignaleingang 104 bereitgestellt. Der erste n-MOS-Logikauswahl-Transistor 108 ist mittels eines ersten Logikauswahlsignals $s_0$ steuerbar. Ferner ist ein zweiter n-MOS-Logikauswahl-Transistor 109 als ein zweites Logikauswahl-Element zwischen dem ersten Datensignaleingang 103 und dem vierten Datensignaleingang 106 bereitgestellt. Der zweite n-MOS-Logikauswahl-Transistor 109 ist mittels eines zweiten Logikauswahlsignals $s_1$ steuerbar. Darüber hinaus ist als drittes Logikauswahl-Element ein dritter n-MOS-Logikauswahl-Transistor 110 zwischen dem zweiten Datensignaleingang 104 und dem dritten Datensignaleingang 105 bereitgestellt, welcher dritte n-MOS-Logikauswahl-Transistor 110 mittels eines dritten Logikauswahlsignals $s_2$ steuerbar ist. Als ein viertes Logikauswahl-Element ist ein vierter n-MOS-Logikauswahl-Transistor 111 zwischen dem dritten Datensignaleingang 105 und dem vierten Datensignaleingang 106 verschaltet, welcher vierte n-MOS-Logikauswahl-Transistor 111 mittels eines vierten Logikauswahlsignals $s_3$ steuerbar ist.

Der erste Datensignaleingang 103 ist mit dem Gate-Bereich eines ersten n-MOS-Datensignal-Transistors 112 gekoppelt. Der zweite Datensignaleingang 104 ist mit dem Gate-Bereich eines zweiten n-MOS-Datensignal-Transistors 113 gekoppelt. Der dritte Datensignaleingang 105 ist mit dem Gate-Bereich eines dritten n-MOS-Datensignal-Transistors 114 gekoppelt. Der vierte Datensignaleingang 106 ist mit dem Gate-Bereich eines vierten n-MOS-Datensignal-Transistors 115 gekoppelt.

Der erste n-MOS-Datensignal-Transistor 112 ist derart verschaltet, dass dessen erster Source-/Drain-Anschluss mit einem ersten Source-/Drain-Anschluss des ersten n-MOS-Logikauswahl-Transistors 108 und mit einem ersten Source-/Drain-Anschluss des zweiten n-MOS-Logikauswahl-Transistors 109 gekoppelt ist. Ein zweiter Source-/Drain Anschluss des n-MOS-Datensignal-Transistors 112 ist mit einem ersten Source-/Drain-Anschluss des dritten n-MOS-Datensignal-Transistors 114 gekoppelt und auf das elektrische Versorgungspotential 126 gebracht. Der dritte n-MOS-Datensignal-Transistor 114 ist derart verschaltet, dass dessen zweiter Source-/Drain-Anschluss mit einem ersten Source-/Drain-Anschluss des vierten n-MOS-Logikauswahl-Transistors 111 und mit einem ersten Source-/Drain-Anschluss des dritten n-MOS-Logikauswahl-Transistors 110 gekoppelt ist. Der zweite n-MOS-Datensignal-Transistor 113 ist derart verschaltet, dass dessen erster Source-/Drain-Anschluss mit einem zweiten Source-/Drain-Anschluss des ersten n-MOS-Logikauswahl-Transistors 108 und mit einem zweiten Source-/Drain-Anschluss des dritten n-MOS-Logikauswahl-Transistors 110 gekoppelt ist. Ein zweiter Source-/Drain-Anschluss des zweiten n-MOS-Datensignal-Transistors 113 ist mit einem ersten Source-/Drain-Anschluss des vierten n-MOS-Datensignal-Transistors 115 gekoppelt. Der vierte n-MOS-Datensignal-Transistor 115 ist derart verschaltet, dass dessen zweiter Source-/Drain-Anschluss mit einem zweiten Source-/Drain-Anschluss des zweiten n-MOS-Logikauswahl-Transistors 109 und mit einem zweiten Source-/Drain-Anschluss des vierten n-MOS-Logikauswahl-Transistors 111 gekoppelt ist. Der zweite Source-/Drain-Anschluss des zweiten n-MOS-Datensignal-Transistors 113 und der erste Source-/Drain-Anschluss des vierten n-MOS-Datensignal-Transistors 115 sind mit dem Datensignalausgang 107b gekoppelt.

Mittels eines ersten Inverters 124 kann aus dem zweiten Datensignal $a_1$ das dazu komplementäre Datensignal $\overline{a_1}$ generiert werden. Mittels eines zweiten Inverters 125 kann aus dem ersten Datensignal $a_0$ das dazu komplementäre Datensignal $\overline{a_0}$ generiert werden. Mittels eines dritten Inverters 128 kann aus dem dritten Datensignal $a_2$ das dazu komplementäre Datensignal $\overline{a_2}$ generiert werden.

Der zweite Logikfunktionsblock 170 des ersten Datensignalpfads 101 ist gemäß dem beschriebenen Ausführungsbeispiel völlig identisch aufgebaut wie der erste Logikfunktionsblock 160 des ersten Datensignalpfads 101. Allerdings kann die Logikteilfunktion, die mittels des zweiten Logikfunktionsblocks 170 realisiert wird, sich von der Logikteilfunktion unterscheiden, welche mittels des ersten Logikfunktionsblocks 160 realisiert wird. Dies ist in Fig.1 dadurch gekennzeichnet, dass Logikauswahlsignale $s_4$ bis $s_7$ des zweiten Logikfunktionsblocks 170 des ersten Datensignalpfads 101 von den Logikfunktionssignalen $s_0$ bis $s_3$ des ersten Logikfunktionsblocks 160 unterschiedlich bezeichnet sind. Somit kann in jedem der Logikfunktionsblöcke 160, 170 voneinander unabhängig eine beliebige logische Verknüpfung der Eingangssignale $a_0$, $a_1$, , $\overline{a_0}$, $\overline{a_1}$ realisiert werden.

Ferner ist ein erster n-MOS-Logik-Transistor 129 bereitgestellt; mit einem ersten Source-/Drain-Anschluss, der mit dem Datensignalausgang 107b des ersten Logikfunktionsblocks 160 gekoppelt ist, mit einem Gate-Anschluss, an dem ein zu einem dritten Datensignal $a_2$ komplementäres drittes komplementäres Eingangssignal $\overline{a_2}$ bereitgestellt ist, und mit einem zweiten Source-/Drain-Anschluss, an dem das Ausgangssignal der Logik-Grundzelle 100 aus den drei Eingangssignalen $a_0$, $a_1$, $a_2$ sowie deren logisch komplementären Signalen $\overline{a_0}$, $\overline{a_1}$, $\overline{a_2}$ gemäß einer vorgegebenen Logikfunktion bereitgestellt ist. Ferner ist ein zweiter n-MOS-Logik-Transistor 130 in der Logik-Grundzelle 100 bereitgestellt, mit einem ersten Source-/Drain-Anschluss, der mit dem ersten Datensignalausgang 107b des zweiten Logikfunktionsblocks 170 gekoppelt ist, mit einem Gate-Anschluss, an dem das dritte Datensignal $a_2$ bereitstellbar ist, und mit einem zweiten Source-/Drain-Anschluss, der mit dem zweiten Source-/Drain-Anschluss des ersten n-MOS-Logik-Transistors 129 gekoppelt ist.

Im Weiteren wird der Aufbau des zweiten Datensignalpfads 102 beschrieben.

Dieser ist in antisymmetrischer Weise zu dem ersten Datensignalpfad 101 verschaltet, so dass in dem zweiten Datensignalpfad 102 ebenfalls ein erster Logikfunktionsblock 140 und ein zweiter Logikfunktionsblock 150 bereitgestellt sind. Anstelle eines ersten n-MOS-Logikauswahl-Transistors 108 ist in dem zweiten Datensignalpfad 102 ein erster p-MOS-Logikauswahl-Transistor 116 bereitgestellt. Der zweite n-MOS-Logikauswahl-Transistor 109 ist durch einen zweiten p-MOS-Logikauswahl-Transistor 117 ersetzt. Der dritte n-MOS-Logikauswahl-Transistor 110 ist durch einen dritten p-MOS-Logikauswahl-Transistor 118 ersetzt. Der vierte n-MOS-Logikauswahl-Transistor 111 ist durch einen vierten p-MOS-Logikauswahl-Transistor 119 ersetzt. Der erste n-MOS-Datensignal-Transistor 112 ist durch einen ersten p-MOS-Datensignal-Transistor 120 ersetzt. Der zweite n-MOS-Datensignal-Transistor 113 ist durch einen zweiten p-MOS-Datensignal-Transistor 121 ersetzt. Der dritte n-MOS-Datensignal-Transistor 114 ist durch einen dritten p-MOS-Datensignal-Transistor 122 ersetzt. Der vierte n-MOS-Datensignal-Transistor 114 ist durch einen vierten p-MOS-Datensignal-Transistor 123 ersetzt. Das Signal an den Gate-Anschlüssen der Datensignal-Transistoren 120 bis 123 ist das jeweils invertierte Signal verglichen mit den Signalen an den Gate-Anschlüssen der Datensignal-Transistoren 112 bis 115 des n-MOS-Datensignalpfades 101. So liegt am Gate des ersten p-MOS-Datensignal-Transistors 120 $a_0$ an, wohingegen am Gate des ersten n-MOS-Datensignal-Transistors 112 $\overline{\overline{a}}_0$ anliegt. Am Gate des zweiten p-MOS-Datensignal-Transistors 121 liegt $a_1$ an, wohingegen am Gate des zweiten n-MOS-Datensignal-Transistors 113 $\overline{\overline{a}}_1$ anliegt. Am Gate des dritten p-MOS-Datensignal-Transistors 122 liegt $\overline{\overline{a}}_0$ an, wohingegen am Gate des dritten p-MOS-Datensignal-Transistors 114 $a_0$ anliegt, und am Gate des vierten p-MOS-Datensignal-Transistors 123 liegt $\overline{\overline{a}}_1$ an, wohingegen am Gate des vierten n-MOS-Datensignal-Transistors 115 $a_1$ anliegt.

Unter Asymmetrie der beiden Datensignalpfade 101, 102 ist zu verstehen, dass deren Anordnung zueinander zwar im Wesentlichen spiegelsymmetrisch ist, wobei die Leitungstypen der einander entsprechenden Transistoren jedoch zueinander komplementär sind, und wobei die Datensignale an den Eingängen von einander entsprechenden Datensignal-Transistoren ebenfalls zueinander komplementär sind. Die Logikauswahlsignale an den Eingängen von einander entsprechenden Logikauswahl-Transistoren sind in den beiden Datensignalpfaden 101, 102 allerdings identisch.

Die miteinander gekoppelten Source-/Drain-Anschlüsse des ersten p-MOS-Datensignal-Transistors 120 und des dritten p-MOS-Datensignal-Transistors 122 sind auf das Versorgungspotential 127 gebracht. Ferner sind die miteinander gekoppelten Source-/Drain-Anschlüsse des zweiten p-MOS-Datensignal-Transistors 121 und des vierten p-MOS-Datensignal-Transistors 123 mit einem Datensignalausgang 107a gekoppelt. An dem Datensignalausgang 107a des ersten Logikfunktionsblocks 140 ist ein Ausgangssignal bereitgestellt, welches einer Verarbeitung der Eingangssignale $a_0$, $a_1$ innerhalb des Logikfunktionsblocks 140 gemäß der darin vorgegebenen Logikteilfunktion entspricht. Ein erster p-MOS-Logik-Transistor 131 weist einen ersten Source-/Drain-Anschluss auf, der mit dem Datensignalausgang 107a des ersten Logikfunktionsblocks 140 gekoppelt ist, einen Gate-Anschluss, an den das dritte Eingangssignal $a_2$ angelegt ist, und einen zweiten Source-/Drain-Anschluss, an dem das Ausgangssignal der Logik-Grundzelle 100 bereitstellbar ist. Ferner ist ein zweiter p-MOS-Logik-Transistor 132 vorgesehen, mit einem ersten Source-/Drain-Anschluss, der mit dem Datensignalausgang 107a des zweiten Logikfunktionsblocks 150 des zweiten Datensignalpfads 102 gekoppelt ist, mit einem Gate-Anschluss, an den das zu dem dritten Eingangssignal $a_2$ komplementäre Signal $\overline{a_2}$ bereitstellbar ist, und mit einem zweiten Source-/Drain-Anschluss, der mit dem zweiten Source-/Drain-Anschluss des ersten p-MOS-Logik-Transistors 131 gekoppelt ist.

An den zweiten Source-/Drain-Anschlüssen der Logikauswahl-Transistoren 128 bis 132 ist somit ein Ausgangssignal y entsprechend der Verknüpfung der drei Eingangssignale $a_0$, $a_1$, $a_2$ sowie deren logisch komplementären Signale $\overline{a_0}$, $\overline{a_1}$, $\overline{a_2}$ gemäß einer vorgebbaren Logikfunktion bereitgestellt.

Die Logik-Grundzelle 100 stellt eine Realisierung einer optimierten Logik-Grundzelle von drei Eingängen $a_0$, $a_1$, $a_2$ in statischer Standard-CMOS-Schaltungstechnik dar. Mittels Vorgebens der ersten bis vierten Logikauswahlsignale $s_0$ bis $s_3$ wird in den ersten Logikfunktionsblöcken 140, 160 der ersten bzw. zweiten Datensignalpfade 101, 102 anschaulich vorgegeben, welche Logikteilfunktion von den Logikfunktionsblöcken 140, 160 realisiert werden soll. Mittels Vorgebens der ersten bis vierten Logikauswahlsignale $s_0$ bis $s_3$ wird somit festgelegt, ob die Kanal-Bereiche der Logikauswahl-Transistoren 108 bis 111 bzw. 116 bis 119 leitend sind oder nicht leitend sind. Dadurch werden bestimmte Signalpfade innerhalb der Logikfunktionsblöcke 140, 160 erlaubt, andere ausgeschlossen. Dies führt zu einer definierten Verknüpfung der Eingangssignale $a_0$, $a_1$, $\overline{a_0}$, $\overline{a_1}$ gemäß einer Logikteilfunktion, die mittels Vorgebens der Logikauswahlsignale $s_0$ bis $s_3$ definiert wird.

In ähnlicher Weise werden mittels Vorgebens der fünften bis achten Logikauswahlsignale $s_4$ bis $s_7$ in den zweiten Logikfunktionsblöcken 150, 170 entsprechende leitende Transistor-Pfade vorgegeben, so dass auch in diesen eine vorgebbare Logikteilfunktion der zwei Eingangsvariablen $a_0$, $a_1$ realisiert werden kann.

Die Verknüpfung der Ausgangssignale der Logikfunktionsblöcke 140, 150, 160, 170 mit dem dritten Datensignal $a_2$ bzw. dessen logisch komplementären Wert $\overline{a_2}$ erfolgt unter Verwendung der Logik-Transistoren 129 bis 132, so dass anschaulich mittels der Schaltung aus Fig.1 Gleichung (1) schaltungstechnisch realisiert ist. Dies führt zu einem Ausgangssignal y, das an einem globalen Datensignalausgang bereitstellbar ist.

Mit der erfindungsgemäßen Logik-Grundzelle 100 ist somit eine Realisierung von Funktionen mit drei Eingängen mit einer sehr geringen Anzahl erforderlicher Transistoren ermöglicht, wobei ein expliziter Multiplexer entbehrlich ist. Das Prinzip, dass diese geringe Anzahl von Transistoren ermöglicht, besteht darin, die dritte (bzw. im verallgemeinerten Fall jede weitere Schaltvariable) im Transistor-Serienpfad derart anzuordnen, dass der Eingang mit der höchsten Wertigkeit direkt den Ausgang schaltet.

Anschaulich gliedert sich die Schaltung der Logik-Grundzelle 100 in ein erstes und zweites p-Kanal-Transistornetzwerk 140, 150 und in ein erstes und ein zweites n-Kanal-Transistornetzwerk 160, 170. Das erste p-Kanal-Transistornetzwerk 140 und das erste n-Kanal-Transistornetzwerk 160 bilden zusammen eine Schaltung, die jede beliebige Funktion zweier Eingänge entsprechend den Schalterbelegungen von $s_0$ bis $s_3$ realisiert. Nimmt $a_2$ einen logischen Wert "0" ein, bildet diese Funktion einen Ausgang der Funktion von drei Eingängen. Das zweite p-Kanal-Transistornetzwerk 150 und das zweite n-Kanal-Transistornetzwerk 170 bilden zusammen eine Schaltung, die jede beliebige Funktion zweier Eingänge entsprechend der Schalterbelegungen $s_4$ bis $s_7$ realisiert. Nimmt $a_2$ einen logischen Wert "1" ein, bildet diese Funktion den Ausgang der Funktion von drei Eingängen. Damit ist wiederum die Shannon-Zerlegung der Funktion von drei Eingängen gemäß Gleichung (1) realisiert. Es wurde eine Multiplexer-Funktionalität erfüllende funktionelle Einheit in Form einer c_(n-1)_MOS Struktur realisiert, wobei n die Anzahl der Eingänge ist.

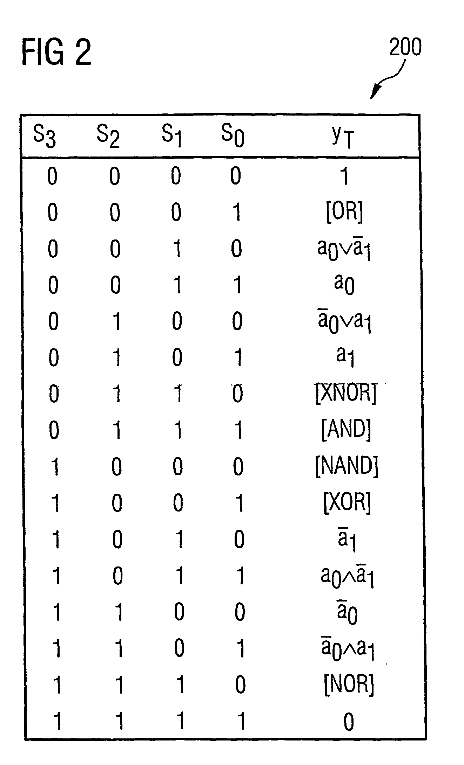

Die in **Fig.2** gezeigte Tabelle 200 gibt für das Beispiel des ersten Logikfunktionsblocks 140 des zweiten Datensignalpfads 102 bzw. für den ersten Logikfunktionsblock 160 des ersten Datensignalpfads 101 an, welche Logikteilfunktion $y_T$ für die unterschiedlichen Permutationen der Logikauswahlsignale $s_0$ bis $s_3$ vorgegeben wird. Zum Beispiel werden die Datensignale $a_0$ und $a_1$ gemäß einer ODER-Logikteilfunktion verknüpft, wenn das erste Logikauswahlsignal $s_0$ einen logischen Wert "1" aufweist, und die zweiten bis vierten Logikauswahlsignale $s_1$ bis $s_3$ jeweils einen logischen Wert "0" aufweisen.

Tabelle 200 zeigt die Belegung der Schaltvariablen $s_0$ bis $s_3$ an, mit Hilfe derer alle möglichen 16 Logikfunktionen zum Verknüpfen von zwei Datensignalen $a_0$ und $a_1$ eingestellt werden können. Höherwertige komplexere Funktionen werden unter Verwendung von Gleichung (2) aufgebaut, indem mehrere Logikfunktionsblöcke 140, 150, 160, 170 miteinander in der in Fig.1 gezeigten Weise verschaltet werden, wobei die Einflüsse des dritten Datensignals $a_2$ mittels der in Fig.1 gezeigten verschalteten Logik-Transistoren 129 bis 132 realisiert wird.

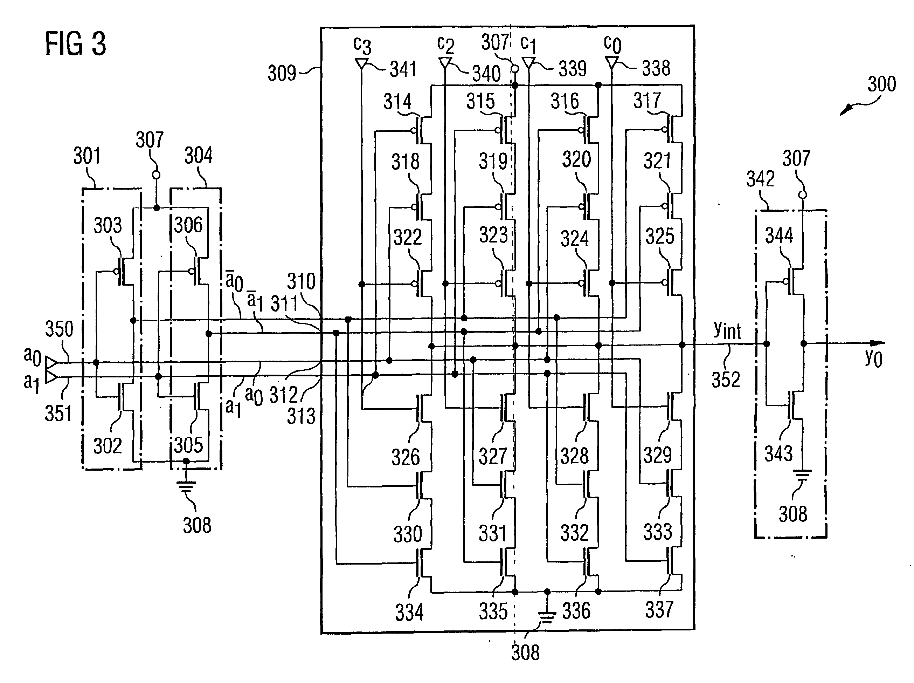

Im Weiteren wird bezugnehmend auf **Fig.3** ein Logikfunktionsblock 300 gemäß einem Ausführungsbeispiel beschrieben, der anstelle der Logikfunktionsblöcke 140, 150, 160, 170 in eine erfindungsgemäße Logik-Grundzelle (z.B. die Logik-Grundzelle 100 aus Fig.1) implementiert werden kann und ebenfalls eine beliebig wählbare Logikteilfunktion erfüllen kann.

Zunächst wird die der Funktionalität des Logikfunktionsblocks 300 der erfindungsgemäßen Logik-Grundzelle zugrundliegende theoretische Basis basierend auf der booleschen Logik beschrieben.

Eine boolesche Funktion lässt sich in der kanonischkonjunktiven Normalform als ODER-Verknüpfung der Produktterme ihrer n Eingänge ausdrücken (in Fig.3 ist beispielsweise n=2, da zwei Eingangssignale $a_1$, $a_0$ bereitgestellt sind). Diesen n Eingängen sind $2^n$ Produktterme zugeordnet.

Auf Standard-CMOS-Logik angewendet werden die Produktterme für den logischen Wert "1" einer Funktion als Serienpfad von p-Kanal-Transistoren realisiert. Der Logik-Wert "0" wird entsprechend als Serienpfad aus n-Kanal-Transistoren realisiert. Entsprechend kann jede Logik-Funktion, gemäß welcher an n Eingängen bereitgestellte Signale miteinander Logik-verknüpft werden, aus $2^n$ Produkttermen zusammengesetzt werden, indem anschaulich Produktterme zu- oder abgeschaltet werden.

Für zwei Eingänge $a_0$ und $a_1$ gilt:

$$y = k_0 \cdot \overline{a_1} \cdot \overline{a_0} \vee k_1 \cdot \overline{a_1} \cdot a_0 \vee k_2 \cdot a_1 \cdot \overline{a_0} \vee k_3 \cdot a_0 \cdot a_1 \qquad (3)$$

$$\overline{y} = k_4 \cdot \overline{\overline{a_1} \cdot \overline{a_0}} \vee k_5 \cdot \overline{\overline{a_1} \cdot a_0} \vee k_6 \cdot \overline{\overline{\overline{a_1}} \cdot a_0} \vee k_7 \cdot \overline{\overline{a_1} \cdot \overline{a_0}} \qquad (4)$$

mit

$$k_i = \{0,1\} \quad \text{mit } i = 0,1,\ldots 7 \qquad (5)$$

Jede Funktion $y=f(a_0, a_1)$ wird gebildet, indem vier Werte der Schaltkoeffizienten oder Logikfunktionsvariablen $k_0$ bis $k_7$ auf einen Wert logisch "1" und die restlichen auf einen Wert logisch "0" gesetzt werden. Da in CMOS-Logik die p-Kanal-Transistoren mit einem elektrischen Potential "0" am Steuer- oder Gate-Anschluss öffnen, die n-Kanal-Transistoren hingegen bei einem elektrischen Potential mit einem Wert "1", lassen sich die Produktterme in Gleichungen (3), (4) zu einander sich ausschließenden Paaren ordnen. In Gleichungen (3), (4) schließen sich die jeweils ersten Produktterme gegenseitig logisch aus, ebenso die jeweils zweiten, die jeweils dritten und die jeweils vierten.

Für die Schaltkoeffizienten $k_i$ gilt die Beziehung:

$$k_0 = \overline{k_4}, \ k_1 = \overline{k_5}, \ k_2 = \overline{k_6}, \ k_3 = \overline{k_7} \qquad (6)$$

Aus Gleichungen (4), (5), (6) ergibt sich nach Zusammenfassen zu vier unabhängigen Schaltvariablen $c_0$, $c_1$, $c_2$, $c_3$:

$$Y = \overline{c_0} \cdot \overline{a_1} \cdot \overline{a_0} \vee \overline{c_1} \cdot \overline{a_1} \cdot a_0 \vee \overline{c_2} \cdot a_1 \cdot \overline{a_0} \vee \overline{c_3} \cdot a_1 \cdot a_0 \qquad (7)$$

$$\overline{Y} = c_0 \cdot \overline{\overline{a_1} \cdot \overline{a_0}} \vee c_1 \cdot \overline{\overline{a_1} \cdot a_0} \vee c_2 \cdot \overline{a_1 \cdot \overline{a_0}} \vee c_3 \cdot \overline{a_1 \cdot a_0} \qquad (8)$$

mit

$$c_i = \{0,1\} \ \text{mit} \ i = 0,1,\ldots 3 \qquad (9)$$

Fig.3 zeigt eine halbleitertechnologische Realisierung der Funktion gemäß Gleichungen (7), (8) auf Basis von Transistoren als möglichen Logikfunktionsblock 140, 150, 160, 170 für eine Logik-Grundzelle 100.

Bei dem Logikfunktionsblock 300 aus Fig.3 ist an einem ersten Datensignal-Eingang 350 ein erstes Datensignal $a_0$ bereitgestellt. Ferner wird an einem zweiten Datensignal-Eingang 351 ein zweites Datensignal $a_1$ bereitgestellt. Mittels eines ersten Inverter-Schaltkreises 301 wird aus dem ersten Datensignal $a_0$ das dazu komplementäre Signal $\overline{a_0}$ gebildet. Der erste Datensignal-Eingang 350 ist mit dem Gate-Bereich eines ersten n-MOS-Inverter-Transistors 302 gekoppelt. Ferner ist der erste Datensignal-Eingang 350 mit dem Gate-Anschluss eines ersten p-MOS-Inverter-Transistors 303 gekoppelt. Ein erster Source-/Drain-Bereich des ersten p-MOS-Inverter-Transistors 303 ist auf das elektrische Versorgungspotential 307 gebracht. Der zweite Source-/Drain-Bereich des ersten p-MOS-Inverter-Transistors 303 ist mit einem ersten Source-/Drain-Bereich des ersten n-MOS-Inverter-Transistors 302 gekoppelt, dessen zweiter Source-/Drain-Bereich auf das elektrische Massepotential 308 gebracht ist.

Ferner ist ein zweiter Inverter-Schaltkreis 304 vorgesehen, mittels welchen aus dem zweiten Datensignal $a_1$ dessen logisch komplementäres Signal $\overline{a_1}$ gebildet wird. Der zweite Datensignal-Eingang 351 ist mit den Gate-Anschlüssen eines zweiten n-MOS-Inverter-Transistors 305 und eines zweiten p-MOS-Inverter-Transistors 306 gekoppelt, welche Transistoren 305, 306 den zweiten Inverter-Schaltkreis 304 bilden. Ein erster Source-/Drain-Bereich des zweiten p-MOS-Inverter-Transistors 306 ist mit dem ersten Source-/Drain-Bereich des ersten p-MOS-Inverter-Transistors 303 gekoppelt, wohingegen der zweite Source-/Drain-Anschluss des zweiten p-MOS-Inverter-Transistors 306 mit einem ersten Source-/Drain-Anschluss des zweiten n-MOS-Inverter-Transistors 305 gekoppelt ist. Der zweite Source-/Drain-Anschluss des zweiten n-MOS-Inverter-Transistors 305 ist auf das elektrische Massepotential 308 gebracht.

Wie in Fig.3 gezeigt, werden die Datensignale und deren logisch komplementäre Werte einer Signalpfad-Einheit 309 bereitgestellt. An einem ersten Signalpfad-Eingang 310 ist das Signal $\overline{a_0}$ bereitgestellt. An einem zweiten Signalpfad-Eingang 311 ist das Signal $\overline{a_1}$ bereitgestellt. An einem dritten Signalpfad-Eingang 312 ist das Signal $a_0$ bereitgestellt. An einem vierten Signalpfad-Eingang 313 ist das Signal $a_1$ bereitgestellt.

Die Signalpfad-Einheit 309 ist gebildet aus ersten bis zwölften p-MOS-Logik-Transistoren 314 bis 325 und aus ersten bis zwölften n-MOS-Logik-Transistoren 326 bis 337. Die ersten bis zwölften p-MOS-Logik-Transistoren 314 bis 325 bilden eine erste Signalpfad-Teileinheit, wohingegen die ersten bis zwölften n-MOS-Logik-Transistoren 326 bis 337 eine zweite Signalpfad-Teileinheit bilden.

An einem ersten Logikfunktions-Eingang 338 ist ein erstes Logikfunktionssignal $c_0$ angelegt. An einem zweiten Logikfunktions-Eingang 339 ist ein zweites Logikfunktionssignal $c_1$ bereitgestellt. An einem dritten Logikfunktions-Eingang 340 ist ein drittes Logikfunktionssignal $c_2$ bereitgestellt. An einem vierten Logikfunktions-Eingang 341 ist ein viertes Logikfunktionssignal $c_3$ bereitgestellt.

Der vierte Logikfunktions-Eingang 341 ist mit dem Gate-Anschluss des neunten p-MOS-Logik-Transistors 322 und mit dem Gate-Anschluss des ersten n-MOS-Logik-Transistors 326 gekoppelt. Der dritte Logikfunktions-Eingang 340 ist mit den Gate-Anschlüssen des zehnten p-MOS-Logik-Transistors 323 und des zweiten n-MOS-Logik-Transistors 327 gekoppelt. Der zweite Logikfunktions-Eingang 339 ist mit den Gate-Anschlüssen des elften p-MOS-Logik-Transistors 324 und des dritten n-MOS-Logik-Transistors 328 gekoppelt. Der erste Logikfunktions-Eingang 338 ist mit den Gate-Anschlüssen des zwölften p-MOS-Logik-Transistors 325 und des vierten n-MOS-Logik-Transistors 329 gekoppelt.

Der erste Datensignal-Eingang 310 ist mit dem Gate-Anschluss des fünften n-MOS-Logik-Transistors 330, des sechsten p-MOS-Logik-Transistors 319, des siebten n-MOS-Logik-Transistors 332 und des vierten p-MOS-Logik-Transistors 317 gekoppelt. Der zweite Datensignal-Eingang 311 ist mit den Gate-Anschlüssen des neunten n-MOS-Logik-Transistors 334, des zehnten n-MOS-Logik-Transistors 335, des dritten p-MOS-Logik-Transistors 316 und des achten p-MOS-Logik-Transistors 321 gekoppelt. Der dritte Datensignal-Eingang 312 ist mit den Gate-Anschlüssen des fünften p-MOS-Logik-Transistors 318, des sechsten n-MOS-Logik-Transistors 331, des siebten p-MOS-Logik-Transistors 320 und des achten n-MOS-Logik-Transistors 333 gekoppelt. Der vierte Datensignal-Eingang 313 ist mit den Gate-Anschlüssen des ersten p-MOS-Logik-Transistors 314, des zweiten p-MOS-Logik-Transistors 315, des elften n-MOS-Logik-Transistors 336 und des zwölften n-MOS-Logik-Transistors 337 gekoppelt.

Erste Source-/Drain-Anschlüsse der ersten bis vierten p-MOS-Logik-Transistoren 314 bis 317 sind auf das elektrische Potential der Versorgungsspannung 307 gebracht. Der zweite Source-/Drain-Anschluss des ersten p-MOS-Logik-Transistors 314 ist mit einem ersten Source-/Drain-Anschluss des fünften p-MOS-Logik-Transistors 318 gekoppelt, dessen zweiter Source-/Drain-Anschluss mit einem ersten Source-/Drain-Anschluss des neunten p-MOS-Logik-Transistors 322 gekoppelt ist. Der zweite Source-/Drain-Anschluss des zweiten p-MOS-Logik-Transistors 315 ist mit einem ersten Source-/Drain-Anschluss des sechsten p-MOS-Logik-Transistors 319 gekoppelt, dessen zweiter Source-/Drain-Anschluss mit einem ersten Source-/Drain-Anschluss des zehnten p-MOS-Logik-Transistors 323 gekoppelt ist. Der zweite Source-/Drain-Anschluss des dritten p-MOS-Logik-Transistors 316 ist mit einem ersten Source-/Drain-Anschluss des siebten p-MOS-Logik-Transistors 320 gekoppelt, dessen zweiter Source-/Drain-Anschluss mit einem ersten Source-/Drain-Anschluss des elften p-MOS-Logik-Transistors 324 gekoppelt ist. Der zweite Source-/Drain-Anschluss des vierten p-MOS-Logik-Transistors 317 ist mit einem ersten Source-/Drain-Anschlüss des achten p-MOS-Logik-Transistors 321 gekoppelt, dessen zweiter Source-/Drain-Anschluss mit einem ersten Source-/Drain-Anschluss des zwölften p-MOS-Logik-Transistors 325 gekoppelt ist.

Die zweiten Source-/Drain-Anschlüsse der neunten bis zwölften p-MOS-Logik-Transistoren 322 bis 325 sind mit dem Ausgang 352 und mit ersten Source-/Drain-Anschlüssen der ersten bis vierten n-MOS-Logik-Transistoren 326 bis 329 gekoppelt. Der zweite Source-/Drain-Anschluss des ersten n-MOS-Logik-Transistors 326 ist mit einem ersten Source-/Drain-Anschluss des fünften n-MOS-Logik-Transistors 330 gekoppelt, dessen zweiter Source-/Drain-Anschluss mit einem ersten Source-/Drain-Anschluss des neunten n-MOS-Logik-Transistors 334 gekoppelt ist. Der zweite Source-/Drain-Anschluss des zweiten n-MOS-Logik-Transistors 327 ist mit einem ersten Source-/ Drain-Anschluss des sechsten n-MOS-Logik-Transistors 331 gekoppelt, dessen zweiter Source-/Drain-Anschluss mit einem ersten Source-/Drain-Anschluss des zehnten n-MOS-Logik-Transistors 335 gekoppelt,ist. Der zweite Source-/Drain-Anschluss des dritten n-MOS-Logik-Transistors 328 ist mit einem ersten Source-/Drain-Anschluss des siebten n-MOS-Logik-Transistors 332 gekoppelt, dessen zweiter Source-/Drain-Anschluss mit einem ersten Source-/Drain-Anschluss des elften n-MOS-Logik-Transistors 336 gekoppelt ist. Ferner ist der zweite Source-/Drain-Anschluss des vierten n-MOS-Logik-Transistors 329 mit einem ersten Source-/Drain-Anschluss des achten n-MOS-Logik-Transistors 333 gekoppelt, dessen zweiter Source-/Drain-Anschluss mit einem ersten Source-/Drain-Anschluss des zwölften n-MOS-Logik-Transistors 337 gekoppelt ist. Die zweiten Source-/Drain-Anschlüsse der neunten bis zwölften n-MOS-Logik-Transistoren 334 bis 337 sind miteinander gekoppelt und auf das elektrische Massepotential 308 gebracht.

An einem Knoten 352 ist das Ausgangssignal $Y_{int}$ bereitgestellt.

Aus dem Ausgangssignal $Y_{int}$ an dem Knoten 352 wird unter Verwendung eines dritten Inverter-Schaltkreises 342 das Logik-Inverse $y_0$ gebildet, das an einem Ausgang des Logikfunktionsblocks 300 bereitgestellt ist. Das Ausgangssignal $y_{int}$ wird durch den dritten Inverter-Schaltkreis 342 geführt, gebildet aus einem dritten n-MOS-Inverter-Transistor 343 und einem dritten p-MOS-Inverter-Transistor 344. Der Ausgang des Logikfunktionsblocks ist mit den Drain-Anschlüssen der Transistoren 344, 343 gekoppelt. Ein erster Source-/Drain-Anschluss des dritten p-MOS-Inverter-Transistors 344 ist auf das elektrische Versorgungspotential 307 gebracht. Der zweite Source-/Drain-Anschluss des dritten p-MOS-Inverter-Transistors 344 ist mit einem ersten Source-/ Drain-Anschluss des dritten n-MOS-Inverter-Transistors 343 gekoppelt, dessen zweiter Source-/Drain-Anschluss auf das elektrische Massepotential 308 gebracht ist. Der zweite Source-/Drain-Anschluss des dritten p-MOS-Inverter-Transistors 344 und der erste Source-/Drain-Anschluss des dritten n-MOS-Inverter-Transistors 343 sind mit dem Ausgang gekoppelt, an dem Signal $y_0$ anliegt. Das Signal $y_0$ kann in einen Logik-Transistor der erfindungsgemäßen Logik-Grundzelle eingekoppelt werden.

Im Weiteren wird die Funktionalität des Logikfunktionsblocks 300 beschrieben.

Die Signalpfad-Einheit 309 führt anschaulich die Logikoperationen mit den Eingabesignalen $\overline{a_0}$, $\overline{a_1}$, $a_0$ und $a_1$ durch. Die Funktionalität von Gleichung (7) wird anschaulich von den in der Fig.3 gezeigten Weise verschalteten p-MOS-Transistoren 314 bis 325 durchgeführt, wohingegen die Logikoperation gemäß Gleichung (8) anschaulich durch die n-MOS-Transistoren 326 bis 337 durchgeführt wird. Zwischen den Datensignal-Eingängen 350, 351 und den Signalpfad-Eingängen 310 bis 313 sind die beiden Inverter-Schaltkreise 301, 304 vorgesehen, um die komplementären Signale $\overline{a_0}$, $\overline{a_1}$ zu generieren. Zwischen Ausgang 352 und dem globalen Ausgang 107a ist der treibende Inverter-Schaltkreis 342 geschaltet. Für den Logikfunktionsblock 300 mit zwei Eingängen 350, 351 werden gemäß dem beschriebenen Ausführungsbeispiel dreißig Transistoren benötigt, nämlich die zwölf p-MOS-Logik-Transistoren 314 bis 325, die zwölf n-MOS-Logik-Transistoren 326 bis 337 und die sechs Transistoren 302, 303, 305, 306, 343, 344. Die Anzahl der Konfigurationsbits bzw. der Logikfunktionssignale ist vier ($c_0$, $c_1$, $c_2$, $c_3$).

Es ist anzumerken, dass anstelle von vier gemeinsamen Logikfunktionssignalen $c_0$ bis $c_3$ alternativ auch die zwölf p-MOS-Logik-Transistoren 314 bis 325 mit vier separaten Logikfunktionssignalen betrieben werden können und die zwölf n-MOS-Logik-Transistoren 326 bis 337 mit vier separaten, von $c_0$ bis $c_3$ unterschiedlichen Logikfunktionssignalen betrieben werden können.

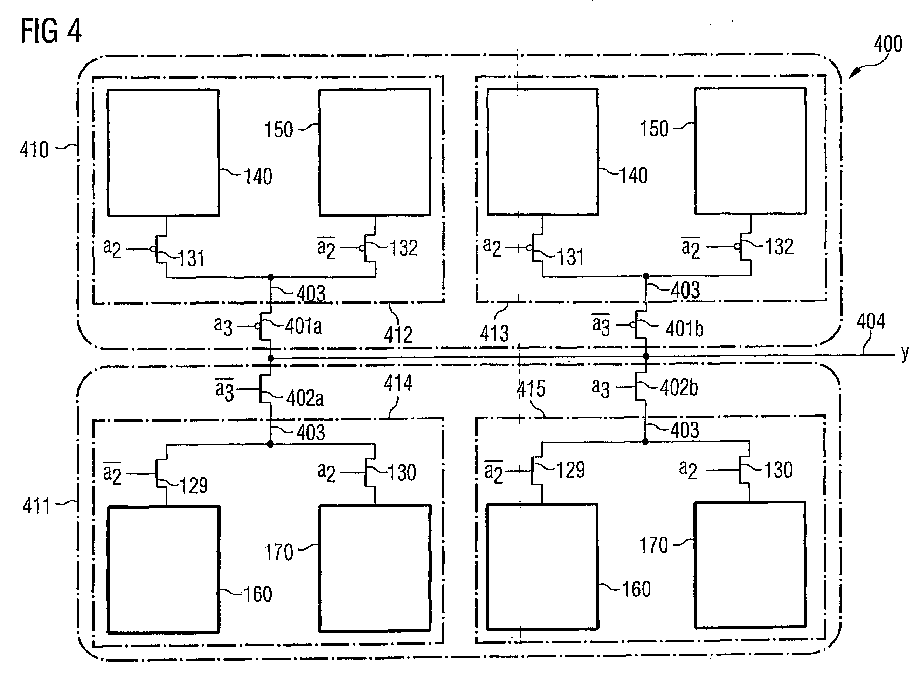

Im Weiteren wird bezugnehmend auf **Fig.4** eine Logik-Grundzellen-Anordnung 400 gemäß einem ersten Ausführungsbeispiel der Erfindung beschrieben.

Die Logik-Grundzellen-Anordnung 400 ist aus zwei im Wesentlichen baugleichen Teilschaltungen, nämlich einer p-MOS-Teilschaltung 410 und einer n-MOS-Teilschaltung 411 gebildet. Die p-MOS-Teilschaltung 410 ist aus p-MOS-Transistoren aufgebaut, wohingegen die n-MOS-Teilschaltung 411 aus n-MOS-Transistoren aufgebaut ist.

Die p-MOS-Teilschaltung 410 ist gebildet aus einer ersten p-MOS-Logik-Grundzelle 412 und aus einer zweiten p-MOS-Logik-Grundzelle 413. Jede der p-MOS-Logik-Grundzellen 412, 413 weist einen ersten p-MOS-Logik-Funktionsblock 140 und einen zweiten p-MOS-Logikfunktionsblock 150 auf, welche mittels des ersten p-MOS-Logik-Transistors 131 und des zweiten p-MOS-Logik-Transistors 132 derart gekoppelt sind, dass an einem Knoten 403 an einem Ausgang der ersten p-MOS-Logik-Grundzelle 412 eine Logik-Verknüpfung von drei Eingangssignalen $a_0$, $a_1$, $a_2$ gebildet ist. In ähnlicher Weise ist an dem Knoten 403 am Ausgang der zweiten p-MOS-Logik-Grundzelle 413, deren innerer Aufbau jener der ersten p-MOS-Logik-Grundzelle 412 entspricht, eine Logikverknüpfung der drei Datensignale $a_0$, $a_1$, $a_2$ bereitgestellt. An dem Ausgang der ersten p-MOS-Logik-Grundzelle 412 ist ein dritter p-MOS-Logik-Transistor 401a angeordnet, mit einem ersten Source-/Drain-Anschluss, an dem das Ausgangssignal der ersten-p-MOS-Logik-Grundzelle 412 angelegt ist, mit einem Gate-Anschluss, an dem ein viertes Eingangssignal $a_3$ bereitgestellt ist, und mit einem zweiten Source-/Drain-Anschluss, an dem das Ausgangssignal y der Logik-Grundzellen-Anordnung 400 bereitgestellt ist.

An dem Ausgang, das heißt an dem Knoten 403, der zweiten p-MOS-Logik-Grundzelle 413 ist ein vierter p-MOS-Logik-Transistor 401b angeordnet, mit einem ersten Source-/Drain-Anschluss, an dem das Ausgangssignal der zweiten p-MOS-Logik-Grundzelle 413 angelegt ist, mit einem Gate-Anschluss, an dem ein zu dem vierten Eingangssignal $a_3$ komplementäres Signal $\overline{a_3}$ bereitgestellt ist, und mit einem zweiten Source-/Drain-Anschluss, der mit dem zweiten Source-/Drain-Anschluss des dritten p-MOS-Logik-Transistors 401a der ersten p-MOS-Logik-Grundzelle 412 gekoppelt ist.

Der Aufbau der n-MOS-Teilschaltung 411 entspricht im Wesentlichen jener der p-MOS-Teilschaltung 410 mit dem Unterschied, dass die darin enthaltenen Komponenten n-Kanal-Transistoren sind, und nicht p-Kanal Transistoren wie in der ersten p-MOS-Logik-Grundzelle 412. Ein erster Logikfunktionsblock 160 aus n-MOS-Transistoren und ein zweiter p-MOS-Logikfunktionsblock 170 aus p-MOS-Transistoren sind gemeinsam mit einem ersten n-MOS-Logik-Transistor 129 und einem zweiten n-MOS-Logik-Transistor 130 derart verschaltet, dass an einem Knoten 403 am Ausgang der ersten n-MOS-Lögik.-Grundzelle 414 ein Ausgangssignal von drei. Datensignalen $a_0$, $a_1$, $a_2$ bereitgestellt ist. In ähnlicher Weise ist an einen Knoten 403 am Ausgang der zweiten n-MOS-Logik-Grundzelle 415 ein Ausgangssignal von drei Datensignalen $a_0$, $a_1$, $a_2$ bereitgestellt. Mittels eines dritten n-MOS-Logik-Transistors 402a am Ausgang 403 der ersten n-MOS-Logik-Grundzelle 414 und mittels eines vierten n-MOS-Logik-Transistors 402b am Ausgang 403 der zweiten n-MOS-Logik-Grundzelle 415 wird am Ausgang 404 der Logik-Grundzellen-Anordnung 400 ein globales Ausgangssignal y generiert.

Der dritte n-MOS-Logik-Transistor 402a hat einen ersten Source-/Drain-Anschluss, an den das Ausgangssignal der ersten n-MOS-Logik-Grundzelle 414 angelegt ist, ferner weist der dritte n-MOS-Logik-Transistor 402a einen Gate-Anschluss auf, an den das zu dem vierten Eingangssignal $a_3$ komplementäre Signal angelegt ist, und weist einen zweiten Source-/Drain-Anschluss auf, an dem das Ausgangssignal y der Logik-Grundzellen-Anordnung 400 bereitgestellt ist. Ferner hat der zweite n-MOS-Logik-Transistor 402b einen ersten Source-/Drain-Anschluss, an dem das Ausgangssignal 403 der zweiten n-MOS-Logik-Grundzelle 415 bereitgestellt ist, einen Gate-Anschluss, an dem das vierte Eingangssignal $a_3$ bereitgestellt ist, und einen zweiten Source-/Drain-Anschluss, der mit dem zweiten Source-/Drain-Anschluss des dritten n-MOS-Logik-Transistors 402a der ersten n-MOS-Logik-Grundzelle 414 gekoppelt ist.

Im Weiteren wird die Funktionalität der Logik-Grundzellen-Anordnung 400 beschrieben.

An den Ausgängen der Logik-Grundzellen 412 bis 415 ist jeweils ein Signal gemäß einer von der jeweiligen Logik-Grundzelle 412 bis 415 realisierten Logikteilfunktion bereitgestellt, welches eine Verknüpfung von zwei Eingangssignalen $a_0$, $a_1$ darstellt. An den Knoten 403, die mit den ersten Source-/Drain-Anschlüssen der Logik-Transistoren 401a, 401b, 402a, 402b gekoppelt sind, ist jeweils ein gemäß Gleichung (1) gebildetes Logik-Teilausgangssignal von drei Datensignalen $a_0$, $a_1$, $a_2$ bereitgestellt. An dem globalen Ausgang 404 der Logik-Grundzellen-Anordnung 400 ist ein Logik-Ausgangssignal y von vier Dateneingangssignalen $a_0$, $a_1$, $a_2$, $a_3$ bereitgestellt, was Gleichung (2) für den Fall n=3 entspricht.

Somit kann erfindungsgemäß eine Funktion von mehr als drei Eingängen (Fig.4 zeigt eine Funktion von vier Eingängen) mit einer Struktur als binärem Baum realisiert werden. Die kapazitive Last an dem globalen Ausgang 404 hängt bei dem binären Baum aus Fig.4 nicht von der Anzahl der Eingänge ab. Sie entspricht stets der Drain-Kapazität der vier Transistoren 401a, 401b, 402a, 402b, die am Ausgang 404 anliegen.

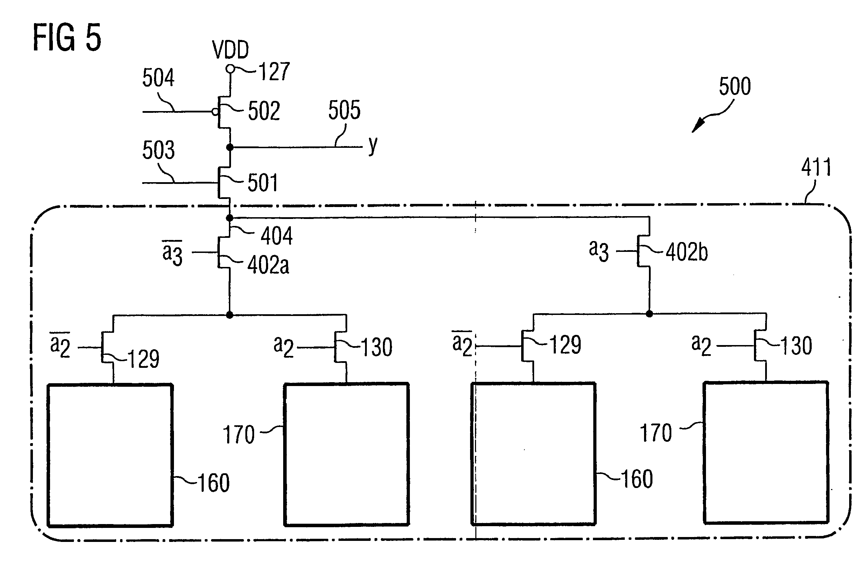

Im Weiteren wird bezugnehmend auf **Fig.5** eine Logik-Grundzellen-Anordnung 500 gemäß einem zweiten Ausführungsbeispiel der Erfindung beschrieben.

Im Unterschied zu der Logik-Grundzellen-Anordnung 400 aus Fig.4 ist die Logik-Grundzellen-Anordnung 500 aus Fig.5 nicht in statischer CMOS-Logik aufgebaut, d.h. Fig.5 zeigt nicht einen p-MOS-Pfad, der im Wesentlichen spiegelgleich zu einem n-MOS-Pfad aufgebaut ist. Die Logik-Grundzellen-Anordnung 500 ist nur aus einem Datensignalpfad gebildet, welcher der n-MOS-Teilschaltung 411 aus Fig.4 entspricht. Somit ist der interne Aufbau der n-MOS-Teilschaltung 411 aus Fig.5 im Wesentlichen identisch zu jener aus Fig.4. Im Unterschied zu der Logik-Grundzellen-Anordnung 400 ist somit bei der Logik-Grundzellen-Anordnung 500 genau ein Datensignalpfad 411 aus n-MOS-Feldeffekttransistoren vorgesehen, wohingegen der in Fig.3 gezeigte Datensignalpfad 410 aus p-MOS-Feldeffekttransistoren eingespart ist. Dies führt zu einer besonders platzsparenden Anordnung.

Ein Ausgabesignal, welches das Ergebnis der Verarbeitung der Datensignale $a_0$, $a_1$, $a_2$, $a_3$ der ausgewählten Logikfunktion darstellt, ist an einem Knoten 404 des Datensignalpfads 411 bereitgestellt, welcher Ausgang mit einem ersten Source-/Drain-Anschluss eines n-MOS-Evaluierungs-Transistors 501 gekoppelt ist. Bei einem entsprechenden Signal an einem mit dem Gate-Bereich des Evaluierungs-Transistors 501 gekoppelten Evaluier-Eingang 503 liegt an einem mit dem zweiten Source-/Drain-Bereich des Evaluierungs-Transistors 501 gekoppelten globalen Ausgang 505 der Logik-Grundzellen-Anordnung 500 das verarbeitete Ausgabesignal an. Der zweite Source-/Drain-Bereich des Evaluierungs-Transistors 501 ist mit einem ersten Source-/Drain-Bereich eines p-MOS-Vorlade-Transistors 502 gekoppelt, dessen zweiter Source-/Drain-Bereich auf das elektrische Versorgungspotential 127 gebracht ist. Bei einem entsprechenden Signal an einem mit dem Gate-Bereich des Vorlade-Transistors 502 gekoppelten Vorlade-Eingang 504 liegt an dem mit dem ersten Source-/Drain-Bereich des Vorlade-Transistors 502 gekoppelten Ausgang 505 der Logik-Grundzellen-Anordnung 500 das elektrische Versorgungspotential 127 als Referenzpotential an.

Verglichen mit Fig.4 ist in Fig.5 somit der Pfad aus p-MOS-Transistoren eingespart. Das Pull-Down-Netzwerk 411 ist in Fig.5 wie in Fig. 4 aus n-MOS-transistoren gebildet, wohingegen in Fig.5 das Pull-Up-Netzwerk 410 aus p-MOS-Transistoren eingespart ist und durch einen statisch oder dynamisch geschalteten Precharge-Transistor 502 ersetzt ist. Alternativ zu Fig.5 kann auch der Signalpfad aus n-MOS-Transistoren gemäß Fig.4 eingespart und durch ein Vorlade-Transistor ersetzt werden, wobei in diesem Fall ein Signalpfad aus p-MOS-Transistoren vorgesehen ist.

Bei der nicht-statischen CMOS-Realisierung der erfindungsgemäßen Logik-Grundzellen-Anordnung 500 gemäß Fig.5 ist somit ein Pull-Up-Transistor 502 vorgesehen, der in einem Teilintervall der Schaltzeit der Logik-Grundzellen-Anordnung 500 den Ausgang 505 auf einen logischen Wert "1" vorlädt (Precharge-Phase), wohingegen in der restlichen Schaltzeit die ausgewählte Logikfunktion im erfindungsgemäß realisierten Pull-down-Pfad 411 errechnet wird (Evaluierungs-Phase).

Alle Schaltungen, die wenigstens einen der beiden Pfade (Pull-Up- oder Pull-down-Pfad) der Struktur von Fig. 4 enthalten, stellen ebenfalls eine Logik-Grundzelle bzw. eine Logik-Grundzellen-Anordnung im Sinne der Erfindung dar, unabhängig davon, wie das jeweils entgegengesetzte Logikpotential realisiert wird.

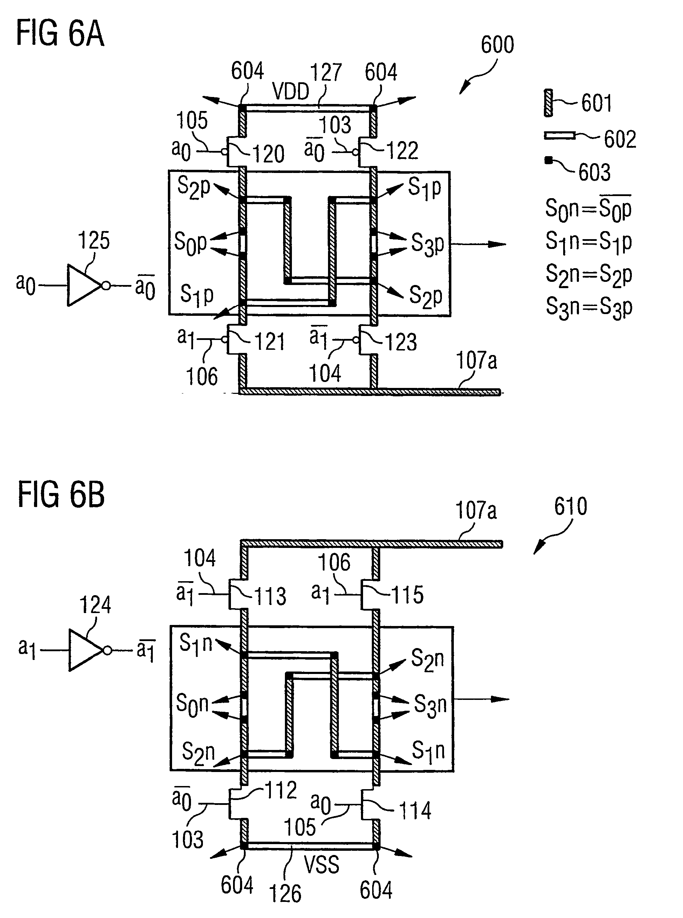

Im Weiteren wird bezugnehmend auf **Fig.6A**, **Fig.6B** eine Alternative zu den ersten und zweiten n-MOS-Teilpfaden 101a, 101b bzw. zu den ersten und zweiten p-MOS-Teilpfaden 102a, 102b der Logik-Grundzelle 100 aus Fig.1 beschrieben.

In Fig.1 wird die Logikteilfunktion, die von den Teilpfaden 101a, 101b, 102a, 102b realisiert wird, mittels Vorgebens von Logikfunktionssignalen $s_0$ bis $s_7$ definiert. Dadurch werden bestimmte Pfade innerhalb des Transistornetzwerkes leitend gemacht, andere Pfade für den Signaltransport ausgeschlossen, so dass die an den Eingängen der Teilpfade 101a, 101b, 102a, 102b bereitgestellten Eingangssignale $a_0$, $a_1$, $\overline{a_0}$, $\overline{a_1}$ gemäß der dadurch ausgewählten Logikteilfunktion.verknüpft werden.

Der in Fig.6A, Fig.6B gezeigte p-MOS-Teilpfad 600 bzw. n-MOS-Teilpfad 610 stellt jeweils eine Realisierung dar, bei der die von den Teilpfaden 600, 610 realisierten LogikTeilfunktionen mittels Festverdrahtens vorgegeben sind. Dass heißt, dass die Logikauswahl-Transistoren aus Fig.1 in Fig.6A, Fig.6B durch Vias bzw. Metallbrücken ersetzt sind.

Der p-MOS-Teilpfad 600 aus Fig.6A unterscheidet sich von dem ersten und zweiten p-MOS-Teilpfaden 102a, 102b aus Fig.1 dadurch, dass die Logikauswahl-Transistoren 116 bis 119 durch fest verdrahtete Kontaktierungselemente ersetzt sind, gebildet aus Komponenten 601 bis 603. Ähnlich unterscheidet sich der n-MOS-Teilpfad 610 aus Fig.6B von den ersten und zweiten n-MOS-Teilpfaden 101a, 101b aus Fig.1 dadurch, dass die Logikauswahl-Transistoren 108 bis 111 durch fest verdrahtete Kontaktierungselemente ersetzt sind, gebildet aus Komponenten 601 bis 603. Die Verschaltung der Datensignal-Transistoren 120 bis 123 bzw. 112 bis 115 in dem p-MOS-Teilpfad 600 bzw. in dem n-MOS-Teilpfad 610 ist hardwaremäßig fest vorgegeben, das heißt mittels Kontaktierungselementen einer ersten Metallisierungsebene 601, einer zweiten Metallisierungsebene 602 mittels Vias 603. Die Vias 603 sind senkrecht zu der Papierebene von Fig.6A, Fig.6B verlaufend gebildet. Die Logikauswahl-Elemente in Fig.6A, Fig.6B sind als unveränderliche Hardwareelemente vorgesehen, realisiert mittels der Metallisierungsebenen 601, 602 und der Vias 603. Die Verdrahtung der Datensignal-Transistoren 112 bis 115.bzw. 120 bis 123 legt eine jeweils fest vorgegebene Logikfunktion fest. Anders ausgedrückt sind in Fig.6A, Fig.6B Konfigurationstransistoren 108 bis 111 bzw. 116 bis 119 durch Viabrücken $s_0p...s_3p$ bzw. $s_0n...s_3n$ ersetzt. Ferner ermöglichen Power-Vias 604, eventuell entfallende Logikpfade von der Versorgungsspannung 127 VDD bzw. von dem Massepotential VSS 126 zu trennen.

Alternativ können die Schalter zwischen einzelnen Transistoren in Fig.6 auch durch alle anderen Via Ebenen, jede beliebige Metalllage, Polysilizium, Diffusionsgebiete oder über jede andere geeignete Ebene eines gegenwärtigen oder eines zukünftigen CMOS-Prozesses hergestellt werden. Die Realisierung aus Fig.6A, Fig.6B ist innerhalb der Standard-CMOS-Schaltungstechnik eine besonders kleine, schnelle und von der Leistungsaufnahme her besonders günstige Realisierung.

In der Realisierung aus Fig.6A, Fig.6B in Standard-CMOS-Technologie werden zwei Eingangsinverter 124, 125 verwendet, zum Erzeugen der Potentiale $\overline{a_0}$, $\overline{a_1}$ aus den Datensignalen $a_0$ bzw. $a_1$. Es ist möglich, die Eingangsinverter 124, 125 einzusparen, indem in dem Pull-Up-Pfad 600 auch n-Kanal-Transistoren und in dem Pull-Down-Pfad 610 auch p-Kanal-Transistoren verwendet werden. Um an einem Ausgang dennoch vollen Spannungshub zu erreichen, werden die Spannungsabfälle mittels Anhebens des Versorgungspotentials bzw. Absenkens des Massepotentials um ein Mehrfaches der Threshold-Spannung (Schwellenspannung) $V_{th}$ kompensiert. Dabei ist bei langen Serienpfaden allerdings die elektrische Belastbarkeit der Transistoren zu beachten. Mit einer solchen Maßnahme lassen sich Anordnungen höchster kombinatorischer Packungsdichte aufbauen, wobei mehrere Versorgungsspannungen bereitgestellt sind.

Die erfindungsgemäße Realisierung der Logik-Grundzelle mit einem expliziten Multiplexer ist besonders dann eine interessante Variante, wenn die Unterfunktionen $f_0$ und $f_1$ aus Gleichung (1) zur weiteren Verwendung auf dem Chip für andere Anwendungen bereitzustellen sind. Ist dies nicht der Fall, ist die erfindungsgemäße Zerlegung mittels eines c_(n-1)_MOS-Struktur eine kompakt zu realisierende Variante, die in der realisierbaren Komplexität möglicherweise durch leicht erhöhte Verzögerungen aufgrund langer Transistorserienpfade begrenzt sein kann. Für sehr komplexe Funktionen kann eine Kombination aus beiden Ansätzen die beste Lösung darstellen. Für kombinatorische Funktionen mit mehr als sechs Eingängen ergeben sich Vereinfachungsmöglichkeiten, da mehr als 16 Funktionen von zwei Eingängen nicht existieren. Insbesondere ist es mit einer Via-programmierten Lösung möglich, sich die Vorteile der Erfindung in effizienter Weise zunutze zu machen.

In diesem Dokument sind folgende Veröffentlichungen zitiert:

[1] Wannemacher, M "Das FPGA-Kochbuch", Abb.6.4: SRAM-Zelle von XILINX, 1. Auflage, International Thomson Publishing Company, Bonn, 1998, S.111;

[2] Wannemacher, M "Das FPGA-Kochbuch", Abb.7.36: Logikblock (CLB) der XC4000-Familien, 1. Auflage, International Thomson Publishing Company, Bonn, 1998, S.197;

[3] US 6,529,040 B1;

[4] US 5,592,107;

[5] H.Kim et al, Design of heuristic algorithms based on Shannon expansion for low power logic circuit synthesis, IEE Proceedings: Circuits Devices and Systems, Great Britain, Band 144, Nr. 6, Dezember 1997, Seiten 355 bis 360;

[6] US 6,130,553 A;

[7] US 2003/0210073 A1;

[8] EP 1 122 888 A1

**Bezugszeichenliste**

100 Logik-Grundzelle
101 erster Datensignalpfad
101a erster n-MOS-Teilpfad
101b zweiter n-MOS-Teilpfad
102 zweiter Datensignalpfad
102a erster p-MOS-Teilpfad
102b zweiter p-MOS-Teilpfad
103 erster Datensignaleingang
104 zweiter Datensignaleingang
105 dritter Datensignaleingang
106 vierter Datensignaleingang
107a Datensignalausgang
107b Datensignalausgang
108 erster n-MOS-Logikauswahl-Transistor
109 zweiter n-MOS-Logikauswahl-Transistor
110 dritter n-MOS-Logikauswahl-Transistor
111 vierter n-MOS-Logikauswahl-Transistor
112 erster n-MOS-Datensignal-Transistor
113 zweiter n-MOS-Datensignal-Transistor
114 dritter n-MOS-Datensignal-Transistor
115 vierter n-MOS-Datensignal-Transistor
116 erster p-MOS-Logikauswahl-Transistor
117 zweiter p-MOS-Logikauswahl-Transistor
118 dritter p-MOS-Logikauswahl-Transistor
119 vierter p-MOS-Logikauswahl-Transistor
120 erster p-MOS-Datensignal-Transistor
121 zweiter p-MOS-Datensignal-Transistor
122 dritter p-MOS-Datensignal-Transistor
123 vierter p-MOS-Datensignal-Transistor
124 erster Inverter
125 zweiter Inverter
126 Massepotential
127 Versorgungspotential
128 dritter Inverter
129 erster n-MOS-Logik-Transistor
130 zweiter n-MOS-Logik-Transistor
131 erster p-MOS-Logik-Transistor
132 zweiter p-MOS-Logik-Transistor
140 erster Logikfunktionsblock
150 zweiter Logikfunktionsblock
160 erster Logikfunktionsblock
170 zweiter Logikfunktionsblock
200 Tabelle
300 Logikfunktionsblock
301 erster Inverter-Schaltkreis
302 erster n-MOS-Inverter-Transistor
303 erster p-MOS-Inverter-Transistor
304 zweiter Inverter-Schaltkreis
305 zweiter n-MOS-Inverter-Transisitor
306 zweiter p-MOS-Inverter-Transistor
307 Versorgungspotential
308 Massepotential
309 Signalpfad-Einheit
310 erster Signalpfad-Eingang
311 zweiter Signalpfad-Eingang
312 dritter Signalpfad-Eingang
313 vierter Signalpfad-Eingang
314 erster p-MOS-Logik-Transistor

315 zweiter p-MOS-Logik-Transistor
316 dritter p-MOS-Logik-Transistor
317 vierter p-MOS-Logik-Transistor
318 fünfter p-MOS-Logik-Transistor
319 sechster p-MOS-Logik-Transistor
320 siebter p-MOS-Logik-Transistor
321 achter p-MOS-Logik-Transistor
322 neunter p-MOS-Logik-Transistor
323 zehnter p-MOS-Logik-Transistor
324 elfter p-MOS-Logik-Transistor
325 zwölfter p-MOS-Logik-Transistor
326 erster n-MOS-Logik-Transistor
327 zweiter n-MOS-Logik-Transistor
328 dritter n-MOS-Logik-Transistor
329 vierter n-MOS-Logik-Transistor
330 fünfter n-MOS-Logik-Transistor
331 sechster n-MOS-Logik-Transistor
332 siebter n-MOS-Logik-Transistor
333 achter n-MOS-Logik-Transistor
334 neunter n-MOS-Logik-Transistor
335 zehnter n-MOS-Logik-Transistor
336 elfter n-MOS-Logik-Transistor
337 zwölfter n-MOS-Logik-Transistor
338 erster Logikfunktions-Eingang
339 zweiter Logikfunktions-Eingang
340 dritter Logikfunktions-Eingang
341 vierter Logikfunktions-Eingang
342 dritter Inverter-Schaltkreis
343 dritter n-MOS-Inverter-Transisitor
344 dritter p-MOS-Inverter-Transistor
350 erster Datensignaleingang
351 zweiter Datensignaleingang
352 Knoten
400 Logik-Grundzellen-Anordnung
401a dritter p-MOS-Logik-Transistor
401b vierter p-MOS-Logik-Transistor
402a dritter n-MOS-Logik-Transistor
402b vierter n-MOS-Logik-Transistor
403 Knoten
404 globaler Knoten
410 p-MOS-Teilschaltung
411 n-MOS-Teilschaltung
412 erste p-MOS-Logik-Grundzelle
413 zweite p-MOS-Logik-Grundzelle
414 erste n-MOS-Logik-Grundzelle
415 zweite n-MOS-Logik-Grundzelle
500 Logik-Grundzellen-Anordnung
501 Evaluierungs-Feldeffekttransistor
502 Vorlade-Feldeffekttransistor
503 Evaluier-Eingang
504 Vorlade-Eingang
505 globaler Ausgang
600 p-MOS-Teilpfad
601 erste Metallisierungsebene
602 zweite Metallisierungsebene
603 Via
604 Power-Via
610 n-MOS-Teilpfad

**Patentansprüche**

1. Logik-Grundzelle (100) zum Bilden eines Ausgangssignals (y) aus mindestens drei Eingangssignalen ($a_0$, $a_1$, $a_2$) gemäß einer vorgebbaren Logikfunktion die gemäß einer Shannon-Zerlegung in mehrere Logikteilfunktionen zerlegt wird, die von einen Eingangssignal nicht abhängen,

   • mit einem ersten Logikfunktionsblock mit zwei Datensignaleingängen (103, 104), an denen ein erstes Eingangssignal und ein zweites Eingangssignal anlegbar sind, und mit einem Datensignalausgang • (107b) zum Bereitstellen einer Logik-Verknüpfung des • ersten Eingangssignals und des zweiten Eingangssignals gemäß einer vorgebbaren Logikteilfunktion;
   • mit einem zweiten Logikfunktionsblock mit zwei Datensignaleingängen (105, 106), an denen das erste Eingangssignal und das zweite Eingangssignal anlegbar sind und mit einem Datensignalausgang (107a) zum Bereitstellen einer Logik-Verknüpfung des
   • ersten Eingangssignals und des zweiten Eingangssignals gemäß einer vorgebbaren zweiten Logikteilfunktion;
   • mit einem ersten Logik-Transistor (129, 130) mit einem ersten Source-/Drain-Anschluss, der mit dem Datensignalausgang (107b) des ersten Logikfunktionsblocks gekoppelt ist, mit einem Gate-Anschluss, an dem ein drittes Eingangssignal bereitstellbar ist, und mit einem zweiten Source-/Drain-Anschluss, an dem das Ausgangssignal (y) bereitstellbar ist;
   • mit einem zweiten Logik-Transistor (131, 132) mit einem ersten Source-/Drain-Anschluss, der mit dem Datensignalausgang (107a) des zweiten Logikfunktionsblocks gekoppelt ist, mit einem Gate-Anschluss, an dem ein zu dem dritten Eingangssignal komplementäres Signal bereitstellbar ist, und mit einem zweiten Source-/Drain-Anschluss, der mit dem zweiten Source-/Drain-Anschluss des ersten Logik-Transistors gekoppelt ist;
   • wobei der erste Logikfunktionsblock und der zweite Logikfunktionsblock jeweils aus einer Mehrzahl von miteinander gemäß der jeweiligen Logikteilfunktion verschalteten Datensignal-Transistoren gebildet sind;
   • wobei die Logiktransistoren und die Datensignal-Transistoren eines ersten Leitungstyps sind, und wobei die Transistoren des ersten Leitungstyps einen ersten Datensignalpfad (101) bilden;
   • wobei ein zweiter Datensignalpfad (102) aus Transistoren eines zweiten Leitungstyps, der zu dem ersten Leitungstyp komplementär ist, gebildet ist, wobei zu jedem der Transistoren des ersten Datensignalpfads (101) ein entsprechend verschalteter Transistor in dem zweiten Datensignalpfad (102) bereitgestellt ist;
   • wobei die zweiten Source/Drain-Anschlüsse der Logik-Transistoren des ersten Datensignalpfads (101) und die zweiten Source/Drain-Anschlüsse der Logik-Transistoren des zweiten Datensignalpfads (102) miteinander gekoppelt sind.

2. Logik-Grundzelle (100) nach Anspruch 1,
   bei welcher der erste Logikfunktionsblock und der zweite Logikfunktionsblock jeweils mindestens einen zusätzlichen Datensignaleingang aufweisen, wobei an jeden der zusätzlichen Datensignaleingänge ein zusätzliches Eingangssignal anlegbar ist, womit die Logik-Grundzelle (100) zum Bilden eines Ausgangssignals aus mindestens vier Eingangssignalen gemäß einer vorgebbaren Logikfunktion eingerichtet ist.

3. Logik-Grundzelle (100) nach Anspruch 1 oder 2,
   mit einem Evaluierungs-Schalter (501), an den das Ausgangsignal (y) anlegbar ist, und mit einem Vorlade-Schalter (502), welche Schalter derart verschaltet und steuerbar sind, dass an einem Ausgang der Logik-Grundzelle (100) bei geöffnetem Evaluierungs-Schalter (501) und geschlossenem Vorlade-Schalter (502) das Ausgangssignal (y) bereitgestellt ist, und dass an dem Ausgang der Logik-Grundzelle (100) bei geöffnetem Vorlade-Schalter (502) und geschlossenem Evaluierungs-Schalter (501) ein Referenzsignal bereitgestellt ist.

4. Logik-Grundzelle (100) nach Anspruch 3,
   bei welcher der Evaluierungs-Schalter (501) und der Vorlade-Schalter (502) jeweils Transistoren sind.

5. Logik-Grundzelle (100) nach einem der Ansprüche 1 bis 4, eingerichtet als ein CMOS-Logik-Grundzelle.

6. Logik-Grundzelle (100) nach einem der Ansprüche 1 bis 5, bei der zumindest eine der Logikfunktionsblöcke als

   • Programmable Logic Device;
   • Field-Programmable Gate-Array;
   • maskenprogrammierter Application-Specific Integrated Circuit;
   • Logik-Gatter oder Anordnung mehrerer Logik-Gatter; oder
   • Look-up-Tabelle,

ausgebildet ist.

**7.** Logik-Grundzelle (100) nach einem der Ansprüche 1 bis 6, bei der zumindest einer der Logikfunktionsblöcke mindestens einen Logikkonfigurationseingang aufweist, mittels welchem dem jeweiligen Logikfunktionsblock die realisierbare Logik-Teilfunktion unveränderlich vorgegeben ist.

**8.** Logik-Grundzelle (100) nach Anspruch 7,
mit einer mit dem mindestens einen
Logikfunktionkonfigurationsseingang gekoppelten SpeicherEinrichtung, in welcher die Information zum Vorgeben der realisierbaren Logik-Teilfunktion speicherbar ist.

**9.** Logik-Grundzelle (100) nach einem der Ansprüche 1 bis 6, bei der zumindest einer der Logikfunktionsblöcke mindestens einen Logikfunktionkonfigurationseingang aufweist, mittels welchem dem jeweiligen Logikfunktionsblock die realisierbare Logik-Teilfunktion mittels eines anlegbaren Signals variabel vorgegeben ist.

**10.** Logik-Grundzelle (100) nach einem der Ansprüche 1 bis 9, bei welcher zumindest einer der Logikfunktionsblöcke ferner aufweist:

• einen ersten Komplementär-Datensignaleingang, an den das zu dem ersten Eingangssignal logisch komplementäre Signal anlegbar ist;
• einen zweiten Komplementär-Datensignaleingang, an den das zu dem zweiten Datensignaleingang logisch komplementäre Signal anlegbar ist;
• ein erstes Logikauswahl-Element (108) zwischen dem ersten Datensignaleingang und dem zweiten Datensignaleingang;
• ein zweites Logikauswahl-Element (109) zwischen dem ersten Datensignaleingang und dem zweiten Komplementär-Datensignaleingang;
• ein drittes Logikauswahl-Element (110) zwischen dem zweiten Datensignaleingang und dem ersten Komplementär-Datensignaleingang;
• ein viertes Logikauswahl-Element (111) zwischen dem ersten Komplementär-Datensignaleingang und dem zweiten Komplementär-Datensignaleingang;

wobei an dem Datensignalausgang die Logik-Verknüpfung der zwei Datensignale gemäß der mittels der Logikauswahl-Elemente (108, 109, 110, 111) ausgewählten Logikfunktion bereitstellbar ist.

**11.** Logik-Grundzelle (100) nach Anspruch 10,
bei der die Logikauswahl-Elemente (108, 109, 110, 111) unveränderliche Hardware-Elemente sind.

**12.** Logik-Grundzelle (100) nach Anspruch 10 oder 11,
bei der die Logikauswahl-Elemente (108, 109, 110, 111) eine Mehrzahl von Metallisierungsebenen und/oder mittels Vias realisiert sind.

**13.** Logik-Grundzelle (100) nach Anspruch 12,
bei der

• das erste Logikauswahl-Element (108) ein erster Logik-Transistor ist, der mittels eines ersten Logikauswahlsignals steuerbar ist;
• das zweite Logikauswahl-Element (109) ein zweiter Logik-Transistor ist, der mittels eines zweiten Logikauswahlsignals steuerbar ist;
• das dritte Logikauswahl-Element (110) ein dritter Logik-Transistor ist, der mittels eines dritten Logikauswahlsignals steuerbar ist;
• das vierte Logikauswahl-Element (111) ein vierter Logik-Transistor ist, der mittels eines vierten Logikauswahlsignals steuerbar ist.

**14.** Logik-Grundzelle (100) nach einem der Ansprüche 10 bis 13, mit vier Datensignal-Transistoren (112, 113, 114, 115), an deren Gate-Anschlüssen jeweils eines der Datensignale oder eines der zu einem der Datensignalen logisch komplementären Datensignale bereitstellbar ist.

**15.** Logik-Grundzelle (100) nach Anspruch 14,

bei der ein erster Datensignal-Transistor (112) derart verschaltet ist, dass dessen

> • erster Source-/Drain-Anschluss mit einem ersten Source-/Drain-Anschluss des ersten Logik-Transistors (129, 130) und mit einem ersten Source-/Drain-Anschluss des zweiten Logik-Transistors (131, 132) gekoppelt ist;
> • zweiter Source-/Drain-Anschluss mit einem ersten Source-/Drain-Anschluss eines dritten Datensignal-Transistors (114) gekoppelt ist.

16. Logik-Grundzelle (100) nach Anspruch 15,
bei welcher der dritte Datensignal-Transistor (114) derart verschaltet ist, dass der zweite Source-/Drain-Anschluss mit einem ersten Source-/Drain-Anschluss des vierten Logik-Transistors (317) und mit einem ersten Source-/Drain-Anschluss des dritten Logik-Transistors (316) gekoppelt ist.

17. Logik-Grundzelle (100) nach einem der Ansprüche 14 bis 16, bei der ein zweiter Datensignal-Transistor (112) derart verschaltet ist, dass dessen

> • erster Source-/Drain-Anschluss mit einem zweiten Source-/Drain-Anschluss des ersten Logik-Transistors (314) und mit einem zweiten Source-/Drain-Anschluss des dritten Logik-Transistors (314) gekoppelt ist;
> • zweiter Source-/Drain-Anschluss mit einem ersten Source-/Drain-Anschluss eines vierten Datensignal-Transistors (115) gekoppelt ist.

18. Logik-Grundzelle (100) nach Anspruch 17,
bei welcher der vierte Datensignal-Transistor (115) derart verschaltet ist, dass dessen zweiter Source-/Drain-Anschluss mit einem zweiten Source-/Drain-Anschluss des zweiten Logik-Transistors (315) und mit einem zweiten Source-/Drain-Anschluss des vierten Logik-Transistors (317) gekoppelt ist.

19. Logik-Grundzellen-Anordnung zum Bilden eines Anordnungs-Ausgangssignals aus mindestens vier Eingangssignalen gemäß einer vorgebaren Logikfunktion, die gemäß einer Shannon-Zerlegung in mehrere Logikteilfunktionen zerlegt wird, die von einem Eingangssignal nicht abhängen,

> • mit einer ersten Logik-Grundzelle (100) nach einem der Ansprüche 1 bis 18;
> • mit einem dritten Logik-Transistor mit einem ersten Source-/Drain-Anschluss, an dem das Ausgangssignal der ersten Logik-Grundzelle (100) anlegbar ist, mit einem Gate-Anschluss, an dem ein viertes Eingangssignal bereitstellbar ist, und mit einem zweiten Source-/Drain-Anschluss, an dem das Ausgangssignal der Logik-Grundzellen-Anordnung bereitstellbar ist;
> • mit einer zweiten Logik-Grundzelle (100) nach einem der Ansprüche 1 bis 18;
> • mit einem vierten Logik-Transistor mit einem ersten Source-/Drain-Anschluss, an dem das Ausgangssignal der zweiten Logik-Grundzelle (100) anlegbar ist, mit einem Gate-Anschluss, an dem ein zu dem vierten Eingangssignal komplementäres Signal bereitstellbar ist, und mit einem zweiten Source-/Drain-Anschluss, der mit dem zweiten Source-/Drain-Anschluss des dritten Logik-Transistors gekoppelt ist.

20. Logik-Vorrichtung zum Bilden einer logischen Verknüpfung von mehr als vier Datensignalen,
mit einer Mehrzahl von Logik-Grundzellen-Anordnungen nach Anspruch 19.

**Claims**

1. A logic basic cell (100) for forming an output signal (y) from at least three input signals ($a_0$, $a_1$, $a_2$) in accordance with a predeterminable logic function, which is resolved according to a Shannon decomposition into a plurality of logic subfunctions, which do not depend from an input signal,

> • having a first logic function block having two data signal inputs (103, 104), to which a first input signal and a second input signal can be applied, and having a data signal output (107b) for providing a logic combination of the first input signal and the second input signal in accordance with a predeterminable logic subfunction;
> • having a second logic function block having two data signal inputs (105, 106), to which the first input signal and the second input signal can be applied, and having a data signal output (107a) for providing a logic combination of the first input signal and the second input signal in accordance with a predeterminable second logic subfunction;
> • having a first logic transistor (129, 130) having a first source/drain terminal, which is coupled to the data signal output (107b) of the first logic function block, having a gate terminal, at which a third input signal can be provided, and having a second source/drain terminal, at which the output signal (y) can be provided;

• having a second logic transistor (131, 132) having a first source/drain terminal, which is coupled to the data signal output (107a) of the second logic function block, having a gate terminal, at which a complementary signal with respect to the third input signal can be provided, and having a second source/drain terminal, which is coupled to the second source/drain terminal of the first logic transistor;

• wherein the first logic function block and the second logic function block are formed in each case of a plurality of data signal transistors being switched with one another in accordance with the respective logic subfunction;

• wherein the logic transistors and the data signal transistors are of a first conduction type, and wherein the transistors of the first conduction type form a first data signal path (101);

• wherein a second data signal path (102) is formed of transistors of a second conduction type, which is complementary to the first conduction type, wherein for each of the transistors of the first data signal path (101) a correspondingly switched transistor is provided in the second data signal path (102);

• wherein the second source/drain terminals of the logic transistors of the first data signal path (101) and the second source/drain terminals of the logic transistors of the second data signal path (102) are coupled with one another.

2. The logic basic cell (100) as claimed in claim 1,
in which the first logic function block and the second logic function block in each case have at least one additional data signal input, it being possible for an additional input signal to be applied to each of the additional data signal inputs, whereby the logic basic cell (100) is set up for forming an output signal from at least four input signals in accordance with a predeterminable logic function.

3. The logic basic cell (100) as claimed in claim 1 or 2, having an evaluation switch (501), to which the output signal (y) can be applied, and having a precharge switch (502), which switches are connected up and can be controlled in such a way that the output signal (y) is provided at an output of the logic basic cell (100) when the evaluation switch (501) is open and the precharge switch (502) is closed, and that a reference signal is provided at the output of the logic basic cell (100) when the precharge switch (502) is open and the evaluation switch (501) is closed.

4. The logic basic cell (100) as claimed in claim 3,
in which the evaluation switch (501) and the precharge switch (502) are in each case transistors.

5. The logic basic cell (100) as claimed in one of claims 1 to 4,
set up as a CMOS logic basic cell.

6. The logic basic cell (100) as claimed in one of claims 1 to 5,
in which at least one of the logic function blocks is formed as

• programmable logic device;
• field-programmable gate array;
• mask-programmed application specific integrated circuit;
• logic gate or arrangement of a plurality of logic gates; or
• look-up table.

7. The logic basic cell (100) as claimed in one of claims 1 to 6,
in which at least one of the logic function blocks has at least one logic function configuration input by means of which the logic subfunction that can be realized is predetermined in an invariable manner for the respective logic function block.

8. The logic basic cell (100) as claimed in claim 7,
having a memory device which is coupled to the at least one logic function configuration input, in which the information for predetermining the logic subfunction that can be realized can be stored.

9. The logic basic cell (100) as claimed in one of claims 1 to 6,
in which at least one of the logic function blocks has at least one logic function configuration input by means of which the logic subfunction that can be realized is predetermined in a variable manner for the respective logic function block by means of a signal that can be applied.

**10.** The logic basic cell (100) as claimed in one of claims 1 to 9,
in which at least one of the logic function blocks furthermore has:

• a first complementary data signal input, to which the logically complementary signal with respect to the first input signal can be applied;
• a second complementary data signal input, to which the logically complementary signal with respect to the second input signal can be applied;
• a first logic selection element (108) between the first data signal input and the second data signal input;
• a second logic selection element (109) between the first data signal input and the second complementary data signal input;
• a third logic selection element (110) between the second data signal input and the first complementary data signal input;
• a fourth logic selection element (111) between the first complementary data signal input and the second complementary data signal input;

it being possible to provide, at the data signal output, the logic combination of the two data signals in accordance with the logic function selected by means of the logic selection elements (108, 109, 110, 111).

**11.** The logic basic cell (100) as claimed in claim 10,
in which the logic selection elements (108, 109, 110, 111) are invariable hardware elements.

**12.** The logic basic cell (100) as claimed in claim 10 or 11,
in which the logic selection elements (108, 109, 110, 111) are realized by means of a plurality of metallization planes and/or by means of vias.

**13.** The logic basic cell (100) as claimed in claim 12,
in which

• the first logic selection element (108) is a first logic transistor, which can be controlled by means of a first logic selection signal;
• the second logic selection element (109) is a second logic transistor, which can be controlled by means of a second logic selection signal;
• the third logic selection element (110) is a third logic transistor, which can be controlled by means of a third logic selection signal;
• the fourth logic selection element (111) is a fourth logic transistor, which can be controlled by means of a fourth logic selection signal.

**14.** The logic basic cell (100) as claimed in one of claims 10 to 13,
having four data signal transistors (112, 113, 114, 115), at the gate terminals of which in each case one of the data signals or one of the logically complementary data signals with respect to one of the data signals can be provided.

**15.** The logic basic cell (100) as claimed in claim 14,
in which a first data signal transistor (112) is connected up in such a way that its

• first source/drain terminal is coupled to a first source/drain terminal of the first logic transistor (129, 130) and to a first source/drain terminal of the second logic transistor (131, 132);
• second source/drain terminal is coupled to a first source/drain terminal of a third data signal transistor (114).

**16.** The logic basic cell (100) as claimed in claim 15,
in which the third data signal transistor (114) is connected up in such a way that the second source/drain terminal is coupled to a first source/drain terminal of the fourth logic transistor (317) and to a first source/drain terminal of the third logic transistor (316).

**17.** The logic basic cell (100) as claimed in one of claims 14 to 16,
in which a second data signal transistor (112) is connected up in such a way that its

• first source/drain terminal is coupled to a second source/drain terminal of the first logic transistor (314) and to a second source/drain terminal of the third logic transistor (314);

• second source/drain terminal is coupled to a first source/drain terminal of a fourth data signal transistor (115).

18. The logic basic cell (100) as claimed in claim 17,
in which the fourth data signal transistor (115) is connected up in such a way that its second source/drain terminal is coupled to a second source/drain terminal of the second logic transistor (315) and to a second source/drain terminal of the fourth logic transistor (317).

19. A logic basic cell array for forming an arrangement output signal from at least four input signals in accordance with a predeterminable logic function, which is resolved according to a Shannon decomposition into a plurality of logic subfunctions, which do not depend from an input signal,

• having a first logic basic cell (100) as claimed in one of claims 1 to 18;
• having a third logic transistor having a first source/drain terminal, to which the output signal of the first logic basic cell (100) can be applied, having a gate terminal, at which a fourth input signal can be provided, and having a second source/drain terminal, at which the output signal of the logic basic cell array can be provided;
• having a second logic basic cell (100) as claimed in one of claims 1 to 18;
• having a fourth logic transistor having a first source/drain terminal, to which the output signal of the second logic basic cell (100) can be applied, having a gate terminal, at which a complementary signal with respect to the fourth input signal can be provided, and having a second source/drain terminal, which is coupled to the second source/drain terminal of the third logic transistor.

20. A logic device for forming a logic combination of more than four data signals,
having a plurality of logic basic cell arrays as claimed in claim 19.

**Revendications**

1. Cellule de base logique ( 100 ) pour former un signal ( y ) de sortie à partir d'au moins trois signaux ( $a_0$, $a_1$, $a_2$) d'entrée suivant une fonction logique pouvant être prescrite, qui est décomposée suivant une décomposition de Shannon en plusieurs sous-fonctions logiques qui ne dépendent pas d'un signal d'entrée,

• comprenant un premier bloc de fonction logique ayant deux entrées ( 103, 104 ) de signal de données, auxquelles peuvent être appliqués un premier signal d'entrée et un deuxième signal d'entrée, et une sortie ( 107b ) de signal de données pour préparer une combinaison logique du premier signal d'entrée et du deuxième signal d'entrée suivant une sous-fonction logique pouvant être prescrite ;
• comprenant un deuxième bloc de fonction logique ayant deux entrées ( 105, 106 ) de signal de données, auxquelles peuvent être appliqués le premier signal d'entrée et le deuxième signal d'entrée, et une sortie ( 107a ) de signal de données pour préparer une combinaison logique du premier signal d'entrée et du deuxième signal d'entrée suivant une deuxième sous-fonction logique pouvant être prescrite ;
• comprenant un premier transistor logique ( 129, 130 ) ayant une première borne de source/drain qui est couplée à la sortie ( 107b ) de signal de données du premier bloc de fonction logique, une borne de grille sur laquelle peut être mis à disposition un troisième signal d'entrée et une deuxième borne de source/drain sur laquelle peut être mis à disposition le signal ( y ) de sortie ;
• comprenant un deuxième transistor logique ( 131, 132 ) ayant une première borne de source/drain qui est couplée à la sortie ( 107a ) de signal de données du deuxième bloc de fonction logique, une borne de grille sur laquelle peut être disponible un signal complémentaire du troisième signal d'entrée et une deuxième borne de source/drain qui est couplée à la deuxième borne de source/drain du premier transistor logique ;
• dans laquelle le premier bloc de fonction logique et le deuxième bloc de fonction logique sont formés respectivement d'une multiplicité de transistors de signal de données câblés entre eux suivant la sous-fonction logique respective ;
• dans laquelle les transistors logiques et les transistors de signal de données sont d'un premier type de conductivité et dans laquelle les transistors du premier type de conductivité forment un premier trajet ( 101 ) de signal de données ;
• dans laquelle un deuxième trajet ( 102 ) de signal de données est formé à partir des transistors d'un deuxième type de conductivité qui est complémentaire du premier type de conductivité, un transistor câblé de manière correspondante dans le deuxième trajet ( 102 ) de signal de données étant mis à disposition pour chacun des transistors du premier trajet ( 101 ) de signal de données ;
• dans laquelle les deuxièmes bornes de source/drain des transistors logiques du premier trajet ( 101 ) de signal de données et les deuxièmes bornes de source/drain des transistors logiques du deuxième trajet ( 102 ) de signal de données sont couplées entre elles.

2. Cellule de base logique ( 100 ) suivant la revendication 1,
   dans laquelle le premier bloc de fonction logique et le deuxième bloc de fonction logique ont respectivement au moins une entrée de signal de données supplémentaire, un signal d'entrée supplémentaire pouvant être appliqué à chacune des entrées de signal de données supplémentaires, de sorte que la cellule de base logique ( 100 ) est réalisée pour former un signal de sortie à partir d'au moins quatre signaux d'entrée suivant une fonction logique pouvant être prescrite.

3. Cellule de base logique ( 100 ) suivant la revendication 1 ou 2,
   comprenant un commutateur ( 501 ) d'évaluation, auquel le signal ( y ) d'entrée peut être appliqué, et un commutateur ( 502 ) de précharge, ces commutateurs étant câblés et pouvant être commandés de façon à disposer, lorsque le commutateur ( 501 ) d'évaluation est ouvert et lorsque le commutateur ( 502 ) de précharge est fermé, du signal ( y ) de sortie, et en ce qu'un signal de référence est disponible à la sortie de la cellule de base logique ( 100 ) lorsque le commutateur ( 502 ) de précharge est ouvert et lorsque le commutateur ( 501 ) d'évaluation est fermé.

4. Cellule de base logique ( 100 ) suivant la revendication 3,
   dans laquelle le commutateur ( 501 ) d'évaluation et le commutateur ( 502 ) de précharge sont respectivement des transistors.

5. Cellule de base logique ( 100 ) suivant l'une des revendications 1 à 4,
   constituée en cellule de base logique CMOS.

6. Cellule de base logique ( 100 ) suivant l'une des revendications 1 à 5,
   dans laquelle au moins l'un des blocs de fonction logique est constitué sous la forme

   • d'un Programmable Logic Device ;
   • d'un Field-Programmable Gate-Array ;
   • d'un Application-Specific Integrated Circuit programmé par masque ;
   • d'une porte logique ou d'une disposition de plusieurs portes logiques; ou
   • d'un tableau look-up.

7. Cellule de base logique ( 100 ) suivant l'une des revendications 1 à 6,
   dans laquelle au moins l'un des blocs de fonction logique a au moins une entrée de configuration logique, au moyen de laquelle la sous-fonction logique réalisable est prescrite sans modification au bloc de fonction logique respectif.

8. Cellule de base logique ( 100 ) suivant la revendication 7,
   comprenant un dispositif de mémoire couplé à la au moins une entrée de configuration de fonction logique, dispositif dans lequel l'information peut être mémorisée pour prescrire la sous-fonction logique réalisable.

9. Cellule de base logique ( 100 ) suivant l'une des revendications 1 à 6,

   • dans laquelle au moins l'un des blocs de fonction logique a au moins une entrée de configuration de fonction logique, au moyen de laquelle la sous-fonction logique réalisable peut être prescrite de manière variable au bloc de fonction logique respectif au moyen d'un signal pouvant être appliqué.

10. Cellule de base logique ( 100 ) suivant l'une des revendications 1 à 9,
    dans laquelle au moins l'un des blocs de fonction logique a en outre:

    • une première entrée de signal de données complémentaire, à laquelle peut être appliqué le signal complémentaire logiquement du premier signal d'entrée ;
    • une deuxième entrée de signal de données complémentaire, à laquelle peut être appliqué le signal complémentaire du deuxième signal de données ;
    • un premier élément ( 108 ) de sélection logique entre la première entrée de signal de données et la deuxième entrée de signal de données ;
    • un deuxième élément ( 109 ) de sélection logique entre la première entrée de signal de données et la deuxième entrée de signal de données complémentaire ;

• un troisième élément ( 110 ) de sélection logique entre la deuxième entrée de signal de données et la première entrée de signal de données complémentaire ;
• un quatrième élément ( 111 ) de sélection logique entre la première entrée de signal de données complémentaire et la deuxième entrée de
• signal de données complémentaire ;

dans laquelle il peut être mis à disposition, sur la sortie de signal de données, la combinaison logique des deux signaux de données suivant la fonction logique sélectionnée au moyen des éléments ( 108, 109, 110, 111 ) de sélection logique.

**11.** Cellule de base logique ( 100 ) suivant la revendication 10,
dans laquelle les éléments ( 108, 109, 110, 111 ) de sélection logique sont des éléments matériels invariables.

**12.** Cellule de base logique ( 100 ) suivant la revendication 10 ou 11,
dans laquelle les éléments ( 108, 109, 110, 111 ) de sélection logique sont réalisés par une multiplicité de plans de métallisation et/ou au moyen de traversées.

**13.** Cellule de base logique ( 100 ) suivant la revendication 12,
dans laquelle

• le premier élément ( 108 ) de sélection logique est un premier transistor logique qui peut être commandé au moyen d'un premier signal de sélection logique ;
• le deuxième élément ( 109 ) de sélection logique
• est un deuxième transistor logique qui peut être commandé au moyen d'un deuxième signal de sélection logique;
• le troisième élément ( 110 ) de sélection logique est un troisième transistor logique qui peut être commandé au moyen d'un troisième signal de sélection logique ;
• le quatrième élément ( 111 ) de sélection logique est un quatrième transistor logique qui peut être commandé au moyen d'un quatrième signal de sélection logique ;

**14.** Cellule de base logique ( 100 ) suivant l'une des revendications 10 à 13,
comprenant quatre transistors ( 112, 113, 114, 115 ) de signal de données aux bornes de grille desquels peut être disponible respectivement l'un des signaux de données ou l'un des signaux de données complémentaires logiquement de l'un des signaux de données.

**15.** Cellule de base logique ( 100 ) suivant la revendication 14,
dans laquelle un premier transistor ( 112 ) de signal de données est câblé, de façon à ce que

• sa première borne de source/drain soit couplée à une première borne de source/drain du premier transistor ( 129, 130 ) logique et à une première borne de source/drain du deuxième transistor ( 131, 132 ) logique ;
• sa deuxième borne de source/drain soit couplée à une première borne de source/drain d'un troisième transistor ( 114 ) de signal de données.

**16.** Cellule de base logique ( 100 ) suivant la revendication 15,
dans laquelle le troisième transistor ( 114 ) de signal de données est câblé, de façon à ce que la deuxième borne de source/drain soit couplée à une première borne de source/drain du quatrième transistor ( 317 ) logique et à une première borne de source/drain du troisième transistor ( 316 ) logique.

**17.** Cellule de base logique ( 100 ) suivant l'une des revendications 14 à 16,
dans laquelle un deuxième transistor ( 112 ) de signal de données est câblé, de manière à ce que

• sa première borne de source/drain soit couplée à une deuxième borne de source/drain du premier transistor ( 314 ) logique et à une deuxième borne de source/drain du troisième transistor ( 314 ) logique ;
• sa deuxième borne de source/drain soit couplée avec une première borne de source/drain d'un quatrième transistor ( 115 ) de signal de données.

**18.** Cellule de base logique ( 100 ) suivant la revendication 17,
dans laquelle le quatrième transistor ( 115 ) de signal de données est câblé, de façon à ce que sa deuxième borne de source/drain soit couplée à une deuxième borne de source/drain du deuxième transistor ( 315 ) logique et à une deuxième borne de source/drain du quatrième transistor ( 317 ) logique.

19. Dispositif de cellule de base logique pour former un signal de sortie de dispositif à partir d'au moins quatre signaux d'entrée suivant une fonction logique pouvant être prescrite, qui est décomposée suivant une décomposition de Shannon en plusieurs sous-fonctions logiques qui ne dépendent pas d'un signal d'entrée,

   • comprenant une première cellule de base logique ( 100 ) suivant l'une des revendications 1 à 18 ;
   • comprenant un troisième transistor logique ayant une première borne de source/drain à laquelle le signal de sortie de la première cellule de base
   • logique ( 100 ) peut être appliqué, ayant une borne de grille à laquelle peut être disponible un quatrième signal d'entrée, et ayant une deuxième borne de source/drain à laquelle peut être disponible le signal de sortie du dispositif de cellule de base logique ;
   • comprenant une deuxième cellule de base logique ( 100 ) suivant l'une des revendications 1 à 18;
   • comprenant un quatrième transistor logique ayant une première borne de source/drain à laquelle le signal de sortie de la deuxième cellule de base logique ( 100 ) peut être appliqué, ayant une borne de grille à laquelle peut être disponible un signal complémentaire du quatrième signal d'entrée, et ayant une deuxième borne de source/drain qui est couplée à la deuxième borne de source/drain du troisième transistor logique.

20. Dispositif logique pour former une combinaison logique de plus de quatre signaux de données, comprenant une multiplicité de dispositifs de cellules de base logiques suivant la revendication 19.

FIG 1

# FIG 2

200

| $S_3$ | $S_2$ | $S_1$ | $S_0$ | $y_T$ |
|-------|-------|-------|-------|-------|
| 0 | 0 | 0 | 0 | 1 |
| 0 | 0 | 0 | 1 | [OR] |
| 0 | 0 | 1 | 0 | $a_0 \vee \bar{a}_1$ |
| 0 | 0 | 1 | 1 | $a_0$ |
| 0 | 1 | 0 | 0 | $\bar{a}_0 \vee a_1$ |
| 0 | 1 | 0 | 1 | $a_1$ |
| 0 | 1 | 1 | 0 | [XNOR] |
| 0 | 1 | 1 | 1 | [AND] |
| 1 | 0 | 0 | 0 | [NAND] |
| 1 | 0 | 0 | 1 | [XOR] |
| 1 | 0 | 1 | 0 | $\bar{a}_1$ |
| 1 | 0 | 1 | 1 | $a_0 \wedge \bar{a}_1$ |
| 1 | 1 | 0 | 0 | $\bar{a}_0$ |
| 1 | 1 | 0 | 1 | $\bar{a}_0 \wedge a_1$ |
| 1 | 1 | 1 | 0 | [NOR] |
| 1 | 1 | 1 | 1 | 0 |

FIG 3

EP 1 723 723 B1

29

FIG 4

EP 1 723 723 B1

FIG 5

EP 1 723 723 B1

## FIG 6A

## FIG 6B

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 6529040 B1
- US 5592107 A
- US 6130553 A
- US 20030210073 A1
- EP 1122888 A1

**In der Beschreibung aufgeführte Nicht-Patentliteratur**

- Das FPGA-Kochbuch. **WANNEMACHER, M.** Abb.6.4: SRAM-Zelle von XILINX. International Thomson Publishing Company, 1998, 111
- Das FPGA-Kochbuch. **WANNEMACHER, M.** Abb.7.36: Logikblock (CLB) der XC4000-Familien. International Thomson Publishing Company, 1998, 197
- **H.KIM et al.** Design of heuristic algorithms based on Shannon expansion for low power logic circuit synthesis. *IEE Proceedings: Circuits Devices and Systems,* Dezember 1997, vol. 144 (6), 355-360